# FASCICULE DE BREVET EUROPEEN

(11) **EP 3 596 435 B1**
(45) Date de publication et mention de la délivrance du brevet: **24.02.2021**
(21) Numéro de dépôt: 18714318.5
(22) Date de dépôt: 14.03.2018
(51) Int. Cl.: G01J 5/04, G01J 5/08

(54) **CAPTEUR DE RAYONNEMENT MUNI D'UNE PROTECTION ANTI-EBLOUISSEMENT**
STRAHLUNGSSENSOR MIT BLENDSCHUTZ
RADIATION SENSOR WITH ANTI-GLARE PROTECTION

(30) Priorité: 15.03.2017 FR 1752109
(43) Date de publication de la demande: 22.01.2020
(73) Titulaire: Commissariat à l'Energie Atomique et aux Energies Alternatives, 75015 Paris (FR)
(72) Inventeur: BECKER, Sébastien, 38500 Voiron (FR); ALIANE, Abdelkader, 38100 Grenoble (FR); PELENC, Denis, 38950 Quaix en Chartreuse (FR); YON, Jean-Jacques, 38360 Sassenage (FR)
(74) Mandataire: Cabinet Beaumont
(86) Numéro de dépôt international: PCT/FR2018/050619
(87) Numéro de publication internationale: WO 2018/167434

(56) Documents cités:
- EP-A2- 1 243 903
- US-A- 6 121 618
- US-A1- 2011 266 445

## Description

### Domaine

La présente demande concerne le domaine des capteurs de rayonnement, et vise plus particulièrement des capteurs du type comportant une pluralité de micro-détecteurs élémentaires, ou pixels, disposés dans et sur un substrat semiconducteur, chaque pixel comportant un élément de conversion d'un rayonnement électromagnétique en un signal électrique, et un circuit de lecture du signal fourni par l'élément de conversion. La présente demande vise plus particulièrement la protection d'un tel capteur contre un éblouissement susceptible d'endommager ses pixels. Les modes de réalisation décrits ci-après sont tout particulièrement avantageux dans le cas où les éléments de conversion des pixels sont des microbolomètres.

### Exposé de l'art antérieur

Un bolomètre comprend classiquement un absorbeur adapté à transformer un rayonnement électromagnétique auquel il est soumis, généralement situé dans l'infrarouge, en énergie thermique, et un thermomètre couplé thermiquement à l'absorbeur et adapté à fournir un signal électrique représentatif de la température de l'absorbeur. Le thermomètre comprend généralement une thermistance, et un circuit de lecture de la résistance électrique de la thermistance.

On a déjà proposé, par exemple dans la demande de brevet français N°2796148 déposée le 8 juillet 1999 ou dans la demande de brevet français N°2822541 déposée le 21 mars 2001, un capteur de rayonnement thermique comportant une pluralité de pixels disposés dans et sur un substrat semiconducteur, chaque pixel comportant un microbolomètre et un circuit électronique de contrôle et de lecture du microbolomètre US20110266445 décrit un capteur de rayonnement ayant un obturateur optique passif.

Un problème qui se pose est que lorsqu'ils sont soumis à un fort rayonnement, par exemple un rayonnement laser dans le cas d'une attaque malveillante du capteur, ou un rayonnement solaire, les pixels d'un tel capteur subissent un échauffement pouvant atteindre plusieurs centaines de degrés, ce qui peut les endommager temporairement ou définitivement.

Plus généralement, cette problématique d'échauffement critique des pixels sous l'effet du rayonnement à détecter peut se poser dans d'autres types de capteurs de rayonnement électromagnétique, notamment des capteurs dans lesquels la mesure du rayonnement incident est basée sur une conversion du rayonnement en énergie thermique au sein des pixels du capteur.

Il serait souhaitable de pouvoir disposer d'un moyen de protection d'un capteur de rayonnement contre un éblouissement susceptible d'endommager ses pixels.

### Résumé

Ainsi, un mode de réalisation prévoit un capteur de rayonnement comportant une pluralité de pixels formés dans et sur un substrat semiconducteur, chaque pixel comportant une microplanche suspendue au-dessus du substrat par des bras d'isolation thermique, la microplanche comprenant dans l'ordre à partir de la face supérieure du substrat:
une couche conductrice adaptée à convertir un rayonnement électromagnétique incident en énergie thermique ; et
un obturateur optique passif comportant une couche thermochrome revêtant l'une des faces de la couche conductrice,
la couche thermochrome étant couplée thermiquement à la couche conductrice et présentant un coefficient de réflexion pour le rayonnement à détecter croissant en fonction de sa température; et une thermistance revêtant la face de la couche thermochrome opposée à la couche conductrice.

Selon un mode de réalisation, la couche thermochrome est en un matériau à changement de phase.

Selon un mode de réalisation, la couche thermochrome est en un oxyde métallique présentant une phase isolante transparente pour le rayonnement à détecter et une phase métallique réfléchissante pour le rayonnement à détecter.

Selon un mode de réalisation, la couche thermochrome est en un oxyde de vanadium ou un oxyde de titane.

Selon un mode de réalisation, la couche thermochrome est en Ag₂S ou en FeS.

Selon un mode de réalisation, la couche thermochrome présente une température de transition comprise entre 60 et 180°C.

Selon un mode de réalisation, chaque pixel comprend en outre une thermistance couplée thermiquement à l'élément de conversion du pixel.

Selon un mode de réalisation, chaque pixel comprend en outre un circuit de lecture de la valeur de la thermistance du pixel.

Selon un mode de réalisation, dans chaque pixel, l'élément de conversion est une couche en un matériau absorbant pour le rayonnement à détecter.

Selon un mode de réalisation, dans chaque pixel, l'élément de conversion est une couche métallique.

Selon un mode de réalisation, dans chaque pixel, les bras d'isolation thermique reposent sur des piliers de connexion électrique verticaux.

Selon un mode de réalisation, dans chaque pixel, la microplanche et les bras d'isolation thermique sont disposés dans une cavité fermée par un capot transparent pour le rayonnement à détecter.

Selon un mode de réalisation, dans chaque pixel, le capot transparent ferme hermétiquement la cavité, et la cavité est à une pression inférieure à la pression atmosphérique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A et 1B sont respectivement une vue en coupe et une vue de dessus simplifiées d'un exemple d'un pixel d'un capteur de rayonnement selon un premier mode de réalisation ;
la figure 2 est une vue en coupe simplifiée d'un autre exemple d'un pixel d'un capteur de rayonnement selon le premier mode de réalisation ;
les figures 3A, 3B, 3C, 3D, 3E et 3F sont des vues en coupe illustrant des étapes d'un exemple d'un procédé de fabrication d'un pixel selon le premier mode de réalisation ;
la figure 4 est une vue en coupe illustrant une variante du procédé de fabrication des figures 3A, 3B, 3C, 3D, 3E et 3F ;
les figures 5A, 5B, 5C et 5D sont des vues en coupe illustrant des étapes d'un autre exemple d'un procédé de fabrication d'un pixel selon le premier mode de réalisation ;
la figure 6 est une vue en coupe partielle et simplifiée d'un exemple d'un pixel d'un capteur de rayonnement selon un deuxième mode de réalisation ;
les figures 7A, 7B, 7C, 7D, 7E et 7F sont des vues en coupe illustrant des étapes d'un exemple d'un procédé de fabrication d'un pixel selon le deuxième mode de réalisation ;

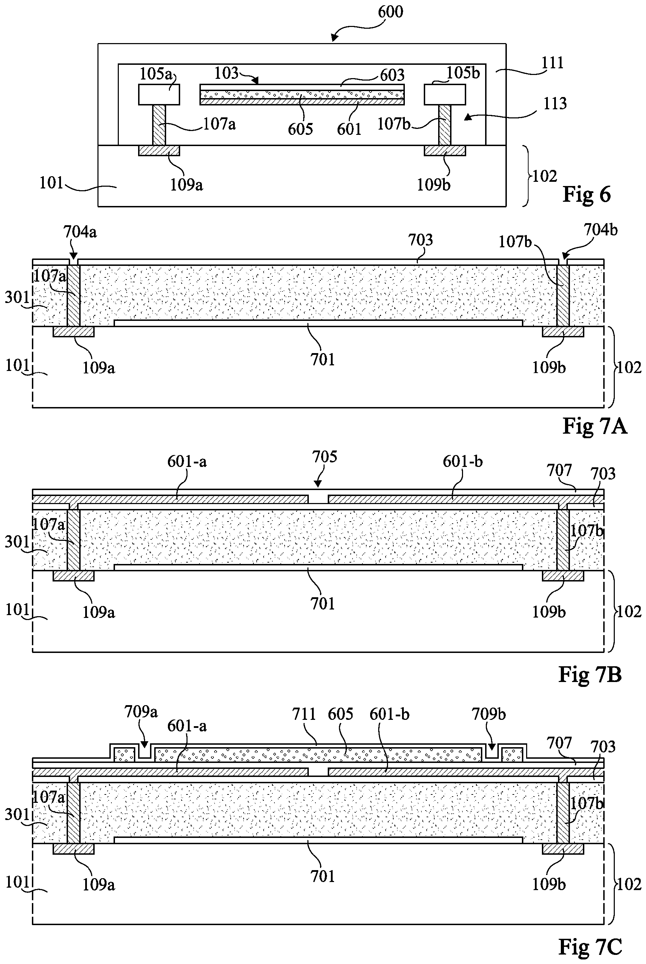

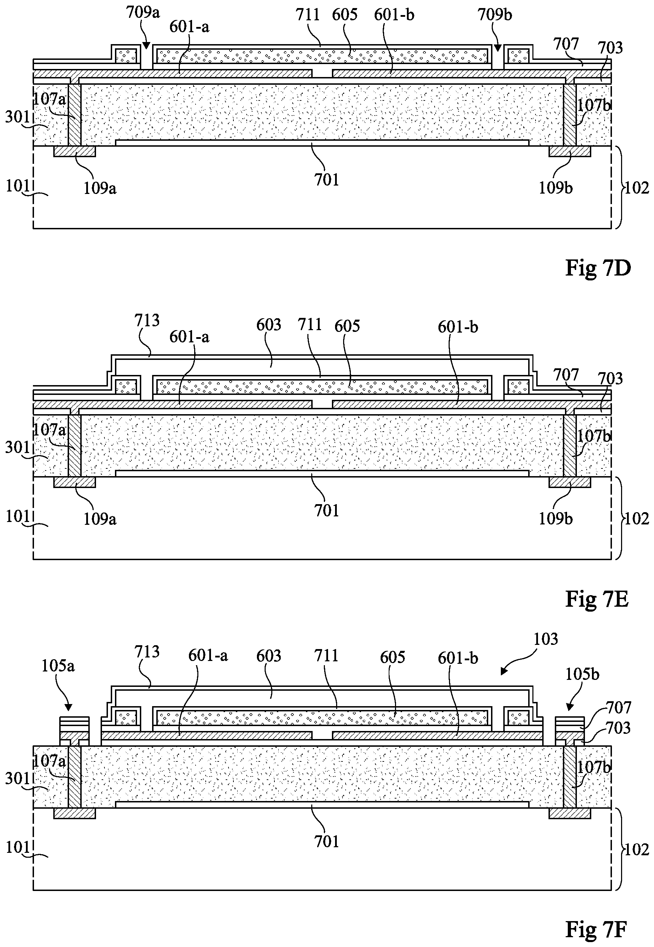

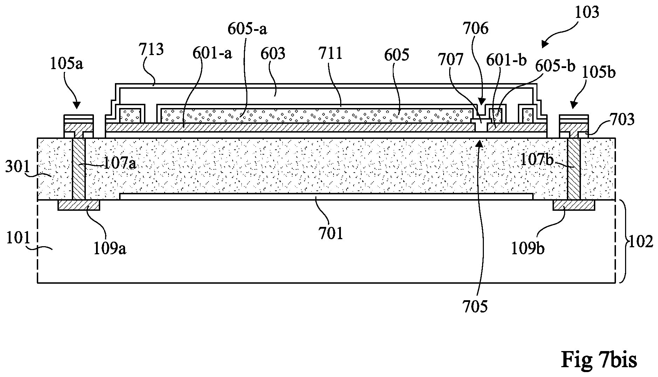

la figure 7bis est une vue en coupe illustrant une variante de réalisation du procédé des figures 7A, 7B, 7C, 7D, 7E et 7F ;

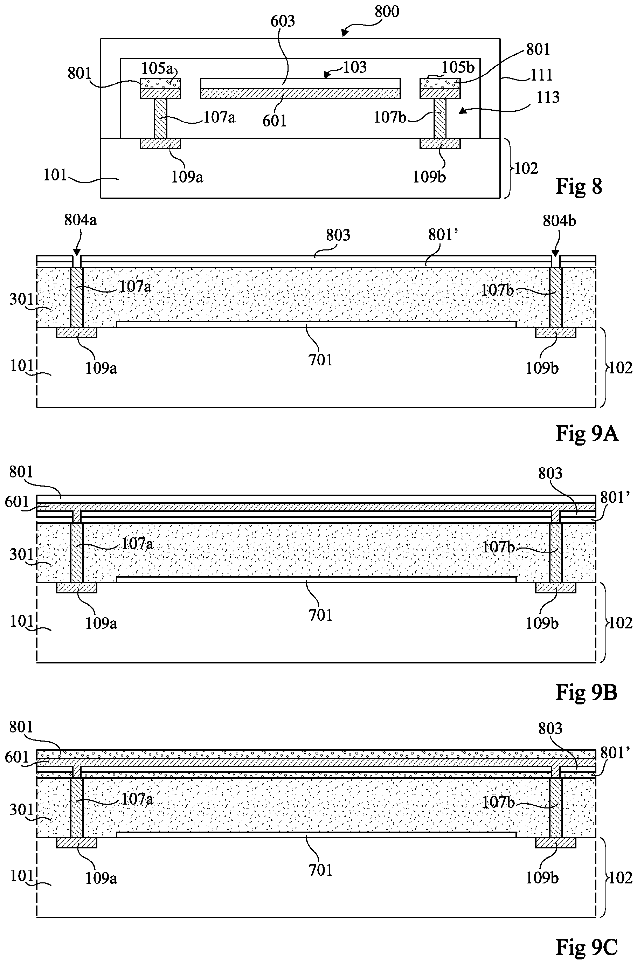

la figure 8 est une vue en coupe simplifiée d'un exemple d'un pixel d'un capteur de rayonnement selon un troisième mode de réalisation ; et

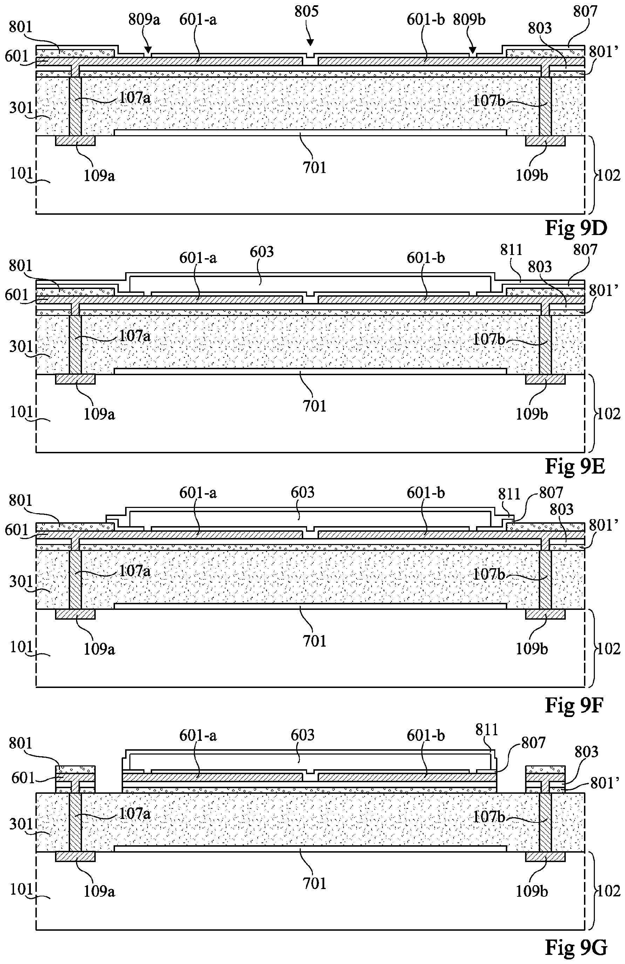

les figures 9A, 9B, 9C, 9D, 9E, 9F et 9G sont des vues en coupe illustrant des étapes d'un exemple d'un procédé de fabrication d'un pixel selon le troisième mode de réalisation.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les circuits de contrôle et de lecture des pixels décrits n'ont pas été détaillés, les modes de réalisation décrits étant compatibles avec les circuits de contrôle et de lecture usuellement prévus dans des pixels de ce type, ou la réalisation de ces circuits étant à la portée de l'homme du métier à partir des indications fonctionnelles de la présente description. De plus, sur les figures illustratives des exemples décrits, un seul pixel d'un capteur de rayonnement est visible. En pratique, les capteurs de rayonnement peuvent comprendre plusieurs pixels identiques ou similaires disposés dans et sur un même substrat semiconducteur, par exemple selon un agencement matriciel ou en barrette. L'agencement des différents pixels du capteur, les interconnexions entre les pixels du capteur, et les circuits périphériques de contrôle du capteur n'ont pas été détaillés, les modes de réalisation décrits étant compatible avec les agencements, interconnexions, et circuits périphériques de contrôle usuellement prévus dans de tels capteurs. Par ailleurs, les utilisations qui peuvent être faites des capteurs décrits n'ont pas été détaillées, les modes de réalisation décrits étant compatibles avec les applications usuelles des capteurs de rayonnement. On notera toutefois que les modes de réalisation décrits sont particulièrement avantageux pour les applications d'imagerie infrarouge, de thermographie, de détection de gaz par mesure de l'absorption optique dans le spectre infrarouge, de détection ou de reconnaissance de personnes, d'objets ou de mouvements dans le spectre infrarouge, etc. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des vues en coupe des figures, étant entendu que, en pratique, les dispositifs décrits peuvent être orientés différemment. Sauf précision contraire, les expressions "approximativement", "sensiblement", et "de l'ordre de" signifient à 10 % près, de préférence à 5 % près. On notera que dans la description qui suit, les capteurs de rayonnement sont destinés à être éclairés ou irradiés par leur face supérieure (dans l'orientation des vues en coupe des figures).

### Premier mode de réalisation - protection active sur capot

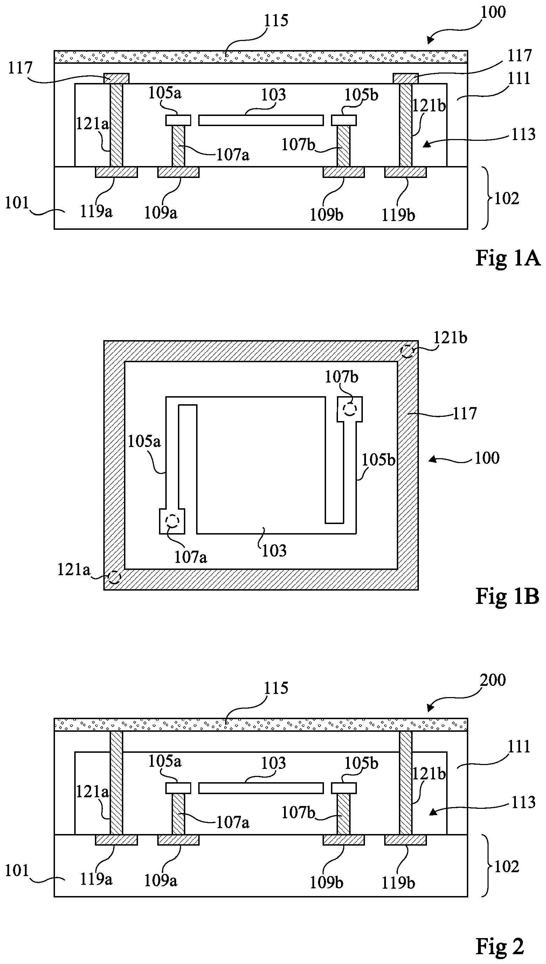

Les figures 1A et 1B sont respectivement une vue en coupe simplifiée et une vue de dessus simplifiée d'un exemple d'un pixel d'un capteur de rayonnement selon un premier mode de réalisation.

Le pixel 100 des figures 1A et 1B est formé dans et sur un substrat semiconducteur 101, par exemple en silicium.

Le pixel 100 comprend un circuit électronique de lecture et de contrôle 102 formé dans et sur le substrat 101, par exemple en technologie CMOS. Le circuit de contrôle et de lecture n'a pas été détaillé sur les figures. Seuls des plots de connexion électrique affleurant la face supérieure du circuit 102, destinés à connecter le circuit 102 à d'autres éléments du pixel, sont représentés sur la figure 1A sous la forme de zones rectangulaires hachurées.

Le pixel 100 comprend en outre une microplanche 103 suspendue au-dessus du circuit 102 par des bras d'isolation thermique, deux bras 105a et 105b dans l'exemple représenté. Plus particulièrement, dans l'exemple représenté, le substrat 101 et le circuit 102 sont disposés horizontalement, et la microplanche 103 et les bras d'isolation thermique 105a et 105b sont disposés dans un même plan moyen sensiblement parallèle à la face supérieure du circuit 102. Chacun des bras 105a et 105b a une première extrémité ou extrémité proximale en contact mécaniquement et électriquement avec la microplanche 103, et une deuxième extrémité ou extrémité distale reposant sur le sommet d'un pilier vertical conducteur 107a, respectivement 107b, par exemple en cuivre ou en tungstène, dont la base repose sur la face supérieure du circuit 102. Les piliers 107a et 107b supportent mécaniquement la microplanche 103 par l'intermédiaire des bras 105a et 105b, et permettent de connecter électriquement la microplanche 103 au circuit 102, également par l'intermédiaire des bras 105a et 105b. Ainsi, un espace libre de tout matériau solide est situé entre la face supérieure du circuit 102 et la face inférieure de la microplanche 103. Autrement dit, la microplanche 103 est en contact mécaniquement uniquement les bras 105a et 105b, qui isolent thermiquement la microplanche du reste de la structure et en particulier du circuit 102 et du substrat 101.

Dans cet exemple, la microplanche 103 est une microplanche bolométrique, c'est-à-dire qu'elle comprend un absorbeur (non détaillé sur les figures 1A et 1B), par exemple sous la forme d'une couche conductrice, adapté à convertir un rayonnement électromagnétique incident en énergie thermique, et une thermistance (non détaillée sur les figures 1A et 1B) permettant de mesurer la température de l'absorbeur. A titre d'exemple, l'absorbeur est en nitrure de titane (TiN) et la thermistance est en silicium amorphe ou en oxyde de vanadium. Les deux extrémités de la thermistance sont connectées électriquement respectivement aux piliers conducteurs 107a et 107b par l'intermédiaire des bras 105a et 105b.

Dans l'exemple représenté la base du pilier de support 107a est en contact mécaniquement et électriquement avec un plot de connexion 109a de la face supérieure du circuit 102, et la base du pilier de support 107b est en contact mécaniquement et électriquement avec un plot de connexion 109b de la face supérieure du circuit 102. Le circuit de contrôle et de lecture 102 est ainsi connecté aux extrémités de la thermistance du pixel par l'intermédiaire des plots 109a et 109b et des piliers 107a et 107b du pixel. Le circuit 102 est adapté à fournir un signal électrique représentatif de la valeur de la résistance électrique de la thermistance du pixel.

Le pixel 100 comprend en outre un capot 111 transparent au rayonnement à détecter, reposant sur la face supérieure du circuit de contrôle 102 et délimitant, avec la face supérieure du circuit 102, une cavité ou enceinte hermétique 113 dans laquelle est située la microplanche suspendue 103. Un espace laissé libre de tout matériau solide est situé entre la face supérieure de la microplanche 103 et la face inférieure du capot 111, cet espace communiquant avec l'espace libre situé entre la face inférieure de la microplanche 103 et la face supérieure du circuit 102. La cavité 113 est de préférence mise sous vide ou sous une pression inférieure à la pression atmosphérique, de façon à renforcer l'isolation thermique de la microplanche 103 vis-à-vis du reste du capteur, en limitant la conduction thermique par l'air.

Selon un aspect du mode de réalisation des figures 1A et 1B, le pixel 100 comprend un obturateur optique comportant une couche 115 en un matériau thermochrome revêtant la face supérieure du capot transparent 111, en regard de la microplanche 103 du pixel. L'obturateur optique est un obturateur actif, c'est-à-dire qu'il est commandable électriquement soit dans un état ouvert dans lequel la couche 115 est sensiblement transparente pour le rayonnement à détecter, c'est-à-dire dans lequel le coefficient de réflexion et/ou d'absorption de la couche 115 pour le rayonnement à détecter est relativement faible, soit dans un état fermé dans lequel le coefficient de réflexion et/ou d'absorption de la couche 115 pour le rayonnement à détecter est relativement élevé, c'est-à-dire supérieur à son coefficient de réflexion et/ou d'absorption à l'état ouvert. A titre d'exemple, le rayonnement à détecter est un rayonnement infrarouge thermique de longueur d'onde comprise dans la bande allant de 8 à 14 µm, et le coefficient de transmission de la couche 115 pour le rayonnement à détecter à l'état fermé est inférieur d'au moins 0,2 et de préférence d'au moins 0,4 à son coefficient de transmission à l'état ouvert.

Dans l'exemple des figures 1A et 1B, l'obturateur comprend une résistance chauffante 117 couplée thermiquement à la couche 115 et connectée au circuit de contrôle 102 du pixel via des plots de connexion 119a et 119b du circuit 102.

Dans l'exemple représenté, la résistance chauffante 117 est disposée, en vue de dessus, à la périphérie de la microplanche bolométrique 103, de façon à ne pas perturber le passage du rayonnement électromagnétique incident vers la microplanche lorsque l'obturateur est à l'état ouvert. A titre d'exemple, la résistance chauffante 117 est un ruban métallique formant un cordon conducteur entourant, en vue de dessus, la microplanche 103. A titre de variante, la résistance chauffante peut être réalisée en un matériau transparent pour le rayonnement à détecter, par exemple un matériau diélectrique ou semiconducteur, par exemple, dans le cas d'un détecteur de rayonnement infrarouge, du dioxyde de vanadium (VO₂), du germanium (Ge), ou un alliage a-SiGe:B de silicium amorphe et de germanium dopé au bore. Dans ce cas, la résistance chauffante 117 peut s'étendre au moins en partie en regard de la microplanche bolométrique 103 du pixel.

La résistance chauffante 117 est par exemple disposée sous la couche thermochrome 115, par exemple accolée à la face inférieure du capot transparent 111. Dans l'exemple représenté, la résistance chauffante 117 est connectée aux plots 119a et 119b du circuit de contrôle 102 respectivement par des piliers conducteurs verticaux 121a et 121b, par exemple en cuivre ou en tungstène, reliant la paroi inférieure à la paroi supérieure de la cavité 113.

Par souci de simplification, seulement la microplanche 103, les bras de maintien 105a et 105b, la résistance chauffante 117, et les piliers de connexion verticaux 107a, 107b, 121a et 121b du pixel 100 ont été représentés sur la figure 1B. De plus, sur la figure 1A, les piliers de connexion verticaux 107a, 107b, 121a et 121b ont été représentés dans un même plan. En pratique, les piliers 107a, 107b, 121a et 121b ne sont toutefois pas nécessairement alignés.

Le fonctionnement de la protection anti-éblouissement du pixel 100 est le suivant. Le circuit de lecture 102 du pixel est adapté à détecter un éblouissement susceptible d'endommager le pixel, par l'intermédiaire de ses plots de connexion 109a et 109b, par exemple par détection d'une variation excessivement rapide et intense de la valeur de la thermistance du pixel, signe d'un échauffement excessivement rapide de la microplanche, ou lorsque la valeur de la thermistance atteint un seuil prédéfini.

A titre d'exemple, le circuit de contrôle et de lecture 102 est adapté, lors d'une phase d'acquisition d'une valeur représentative du rayonnement électromagnétique reçu par le pixel, à mettre en oeuvre une lecture du pixel par intégration, dans un élément capacitif du circuit 102, d'un courant débité par la thermistance du microbolomètre du pixel pour une tension de polarisation continue déterminée de la thermistance.

Dans un mode de réalisation préféré, le circuit 102 est configuré pour intégrer le courant débité par la thermistance du pixel pendant deux périodes d'intégration successives de durées distinctes. Plus particulièrement, le circuit 102 est adapté à mesurer le courant intégré pendant une période d'intégration courte, par exemple de durée comprise entre 1 et 5 µs, pour détecter un éventuel éblouissement du pixel, puis pendant une période d'intégration longue, par exemple de l'ordre de 30 à 100 µs, par exemple d'environ 64 µs, pour l'acquisition proprement dite d'une valeur représentative du rayonnement reçu par le pixel (ou valeur de sortie du pixel), par exemple en vue de la construction d'une image. Le signal issu de la première intégration peut être échantillonné et comparé à un seuil, par exemple par un comparateur, l'obturateur étant alors commandé en fonction du résultat de la comparaison.

A titre de variante, avant la mise en oeuvre de la période d'intégration longue, le circuit 102 peut être adapté à intégrer le courant débité par la thermistance pendant deux périodes d'intégration courtes successives de durées distinctes, par exemple pendant une première période de l'ordre de 1 µs et pendant une deuxième période de l'ordre de 5 µs. L'écart entre les signaux issus des première et deuxième périodes d'intégration courtes est alors déterminé et comparé à un seuil pour décider d'activer ou non l'obturateur. Un avantage est que ceci permet de s'affranchir des écarts de valeurs entre les thermistances des différents pixels, liés aux dispersions technologiques, et ainsi d'améliorer la précision de détection d'un éblouissement.

Dans une autre variante, le circuit de contrôle et de lecture 102 est adapté, lors d'une phase d'acquisition d'une valeur représentative du rayonnement électromagnétique reçu par le pixel, à mettre en oeuvre une lecture du pixel par mesure de la tension aux bornes de la thermistance du microbolomètre du pixel pour un courant de polarisation continu déterminé injecté dans la thermistance du pixel. La tension aux bornes de la thermistance peut alors être comparée à un seuil pour décider d'activer ou non l'obturateur du pixel.

Lorsqu'un éblouissement est détecté, le circuit 102 commande l'application d'un courant dans la résistance 117, de façon à provoquer un échauffement de la couche thermochrome 115 jusqu'à une température de transition conduisant à faire passer l'obturateur de l'état ouvert (couche 115 transparente au rayonnement à détecter) à l'état fermé (couche 115 opaque pour le rayonnement à détecter). Le rayonnement électromagnétique incident est alors stoppé ou limité par la couche 115, ce qui permet d'éviter ou de limiter une dégradation de la microplanche bolométrique du pixel. Après une période de fermeture prédéterminée ou lorsque le circuit 102 détecte un retour à une température acceptable prédéterminée de la microplanche bolométrique, le circuit 102 interrompt le courant circulant dans la résistance chauffante 117. La température de la couche thermochrome 115 redescend alors sous sa température de transition, de sorte que l'obturateur se rouvre.

On notera que les piliers de connexion électrique 121a et 121b permettent avantageusement de coupler thermiquement la partie supérieure du capot de protection 111 au substrat 101, de façon à circonscrire l'échauffement produit par la résistance de chauffe 117, et éviter que la chaleur produite par la résistance 117 se propage dans les capots d'encapsulation et/ou dans les couches thermochromes des pixels voisins. Pour améliorer le couplage thermique avec le substrat 101, le nombre de piliers verticaux de connexion électrique entre la résistance 117 et le circuit 102 peut être supérieur à deux. A titre d'exemple, dans le cas d'une microplanche bolométrique 103 de forme générale carrée ou rectangulaire et d'une résistance chauffante 117 en forme de bande annulaire carrée ou rectangulaire entourant en vue de dessus la microplanche 103, tel que représenté en figure 1B, le pixel peut comporter quatre piliers de connexion électrique disposés respectivement, en vue de dessus, aux quatre coins de la bande annulaire conductrice formant la résistance chauffante.

Par ailleurs, le circuit de contrôle et de lecture 102 du pixel 100 peut être adapté à réguler le courant injecté dans la résistance chauffante 117 en fonction de la température d'utilisation du capteur, de façon à injecter dans la résistance 117 uniquement le courant nécessaire pour obtenir la fermeture de l'obturateur. En effet, la température d'utilisation d'un capteur de rayonnement peut généralement varier dans une large plage, par exemple allant de -40°C à +70°C, et le courant à injecter dans la résistance 117 pour obtenir la transition de la couche thermochrome 115 est d'autant plus élevé que la température d'utilisation est faible. A titre d'exemple, le capteur comprend au moins une sonde de température, par exemple disposée dans et sur le substrat semiconducteur 101, par exemple une sonde à base de jonctions PN. Le circuit de contrôle et de lecture 102 du pixel 100 est alors adapté, en cas d'éblouissement du pixel, à injecter dans la résistance chauffante 117 du pixel un courant choisi en fonction de la température mesurée par la sonde de température. Un avantage est que ceci permet de limiter la consommation électrique liée à la protection anti-éblouissement, notamment lorsque le capteur est utilisé à des températures élevées, et d'éviter un échauffement inutile du capot d'encapsulation 111 des pixels au-delà de la température de transition de la couche thermochrome.

Le matériau de la couche thermochrome 115 est par exemple un matériau à changement de phase présentant, en dessous d'une température de transition, une phase sensiblement transparente pour le rayonnement à détecter, et, au-dessus de la température de transition, une phase réfléchissante ou absorbante pour le rayonnement à détecter. La température de transition du matériau thermochrome est de préférence choisie supérieure à la température maximale que peut atteindre le capot 111 du pixel en fonctionnement normal, par exemple comprise entre 60 et 180°C. La variation du coefficient de transmission ou de réflexion de la couche thermochrome autour de la température de transition est de préférence relativement abrupte, par exemple supérieure à 2,5% par degré pour une longueur d'onde de 10 µm. A titre d'exemple, le matériau thermochrome est un oxyde métallique cristallisé présentant une phase isolante transparente en dessous de sa température de transition, et une phase métallique réfléchissante au-dessus de sa température de transition. Le matériau thermochrome est par exemple du dioxyde de vanadium (VO₂) cristallisé, présentant une température de transition de l'ordre de 68°C. A titre de variante, le matériau thermochrome est du dioxyde de vanadium cristallisé et dopé par des cations de basse valence, par exemple Al3+, Cr3+ ou Ti4+, de façon à augmenter sa température de transition. Plus généralement, selon la température de transition recherchée, d'autres oxydes de vanadium peuvent être utilisés, par exemple du V₃O₅. A titre de variante, le matériau thermochrome de la couche 115 est du Ti₃O₅, du Ti₂O₃, ou du SmNiO₃. A titre de variante, le matériau thermochrome de la couche 115 est un nickelate de terre rare de composition générale RNiO₃, où R désigne une terre rare ou un alliage binaire de terre rare, par exemple un composé de type SmₓNd₁₋ₓNiO₃ ou EuₓSm₁₋ₓNiO₃. A titre de variante, le matériau thermochrome de la couche 115 est du Ag₂S ou du FeS. A titre de variante, le matériau thermochrome est du germanium monocristallin, qui présente l'avantage d'être relativement transparent pour un rayonnement infrarouge thermique à température ambiante, et relativement absorbant pour ce rayonnement pour des températures supérieures à 100°C.

La figure 2 est une vue en coupe simplifiée d'un autre exemple d'un pixel d'un capteur de rayonnement selon le premier mode de réalisation. Le pixel 200 de la figure 2 comprend des éléments communs avec le pixel 100 des figures 1A et 1B. Ces éléments ne seront pas détaillés à nouveau ci-après. Dans la suite, seules les différences entre les pixels 100 et 200 seront détaillées.

Le pixel 200 de la figure 2 diffère du pixel 100 des figures 1A et 1B principalement en ce qu'il ne comporte pas de résistance chauffante 117 distincte de la couche thermochrome 115 pour commander les transitions à l'état fermé ou à l'état ouvert de la couche 115. Dans cet exemple, les extrémités supérieures des piliers de connexion 121a et 121b du pixel sont directement en contact électriquement avec la couche thermochrome 115.

Le fonctionnement du pixel 200 de la figure 2 est sensiblement le même que celui du pixel 100 des figures 1A et 1B, à ceci près que, dans l'exemple de la figure 2, lorsque le circuit de contrôle et de lecture 102 du pixel détecte un éblouissement, il injecte un courant électrique directement dans la couche thermochrome 115, par l'intermédiaire des plots de connexion 119a et 119b et des piliers de connexion 121a et 121b. Ce courant provoque un échauffement de la couche thermochrome 115, conduisant à la fermeture de l'obturateur. Lorsque le courant circulant dans la couche thermochrome 115 est interrompu, la température de la couche 115 redescend sous sa température de transition, de sorte que l'obturateur repasse à l'état ouvert.

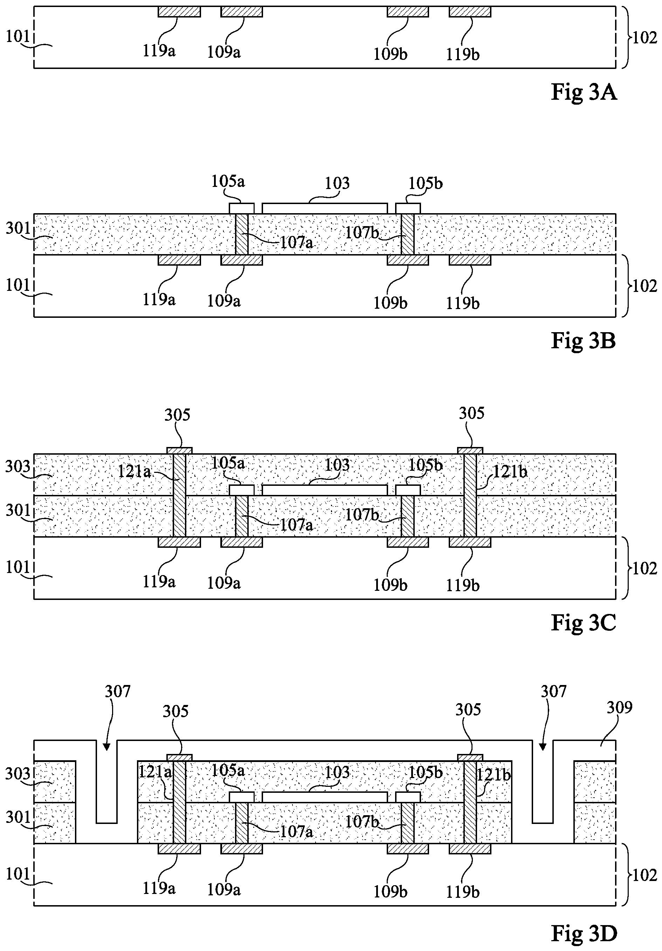

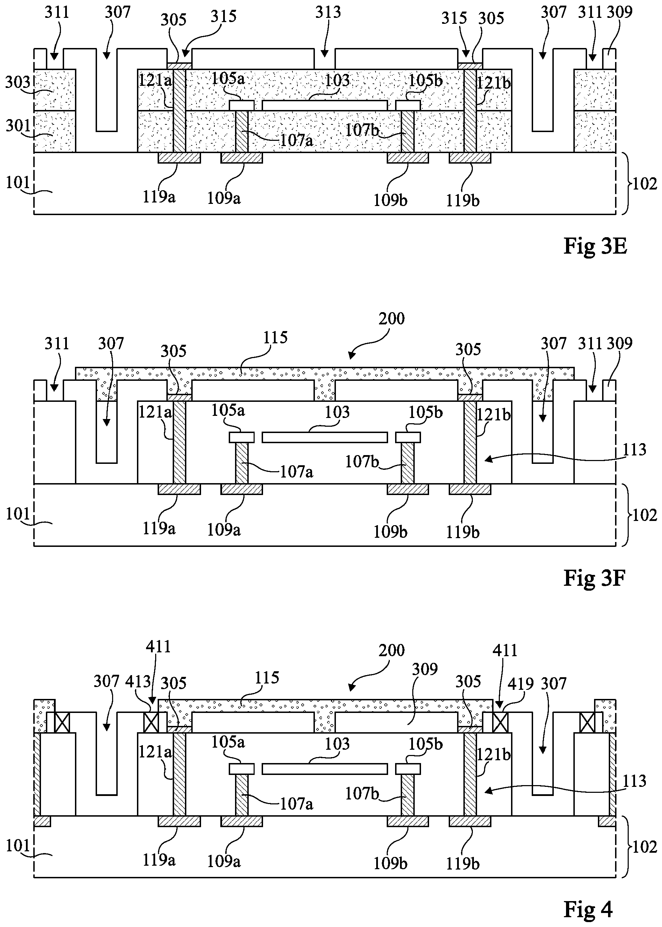

Les figures 3A, 3B, 3C, 3D, 3E et 3F sont des vues en coupe illustrant des étapes d'un exemple d'un procédé de fabrication d'un capteur de rayonnement du type décrit en relation avec la figure 2, c'est-à-dire ne comportant pas de résistance chauffante distincte de la couche thermochrome pour commander les transitions à l'état fermé ou à l'état ouvert de la couche thermochrome. Les figures 3A, 3B, 3C, 3D, 3E et 3F illustrent plus particulièrement la réalisation d'un unique pixel du capteur, étant entendu que, en pratique, une pluralité de pixels identiques ou similaires peuvent être formés simultanément dans et sur un même substrat semiconducteur 101.

La figure 3A illustre une étape de fabrication du circuit de contrôle et de lecture 102 du pixel 200, dans et sur le substrat 101. Le circuit 102 est par exemple réalisé en technologie CMOS. La fabrication du circuit 102 n'est pas détaillée ici, la réalisation de ce circuit étant à la portée de l'homme du métier à partir des indications fonctionnelles mentionnées ci-dessus. Sur la figure 3A, seuls les plots de connexion électrique 109a, 109b, 119a et 119b du circuit 102, affleurant au niveau de la face supérieure du circuit 102, ont été représentés.

La figure 3B illustre une étape de dépôt d'une couche sacrificielle 301 sur et en contact avec la face supérieure du circuit 102. La couche 301 est par exemple déposée de façon continue sur sensiblement toute la surface du substrat 101. A titre d'exemple, la couche 301 est en polyimide ou en oxyde de silicium. L'épaisseur de la couche 301 fixe la distance entre la face supérieure du circuit 102 et la microplanche bolométrique 103 du pixel 200. A titre d'exemple, la couche 301 a une épaisseur comprise entre 1 et 5 µm, par exemple de l'ordre de 2,5 µm.

La figure 3B illustre en outre la formation des piliers de connexion électrique 107a et 107b du pixel, dans des vias gravés dans la couche sacrificielle 301 à l'aplomb des plots de connexion 109a et 109b du circuit 102. Les piliers 107a et 107b s'étendent verticalement sur sensiblement toute l'épaisseur de la couche 301, depuis la face supérieure des plots de connexion 109a et 109b du circuit 102, jusqu'à la face supérieure de la couche 301.

La figure 3B illustre de plus la formation de la microplanche bolométrique 103 et des bras de maintien 105a, 105b de la microplanche, sur et en contact avec la face supérieure de la couche sacrificielle 301 et des piliers de connexion 107a et 107b. Cette étape comprend le dépôt des matériaux constitutifs de la microplanche bolométrique 103 et des bras de maintien 105a, 105b, et la délimitation ou individualisation de la microplanche 103 et des bras 105a, 105b du pixel. La formation de la microplanche bolométrique 103 et des bras de maintien 105a, 105b n'est pas détaillée ici, celle-ci pouvant être mise en oeuvre par des procédés connus de l'homme du métier, par exemple des procédés du type décrit dans les demandes de brevet français N°2796148 et N°2822541 susmentionnées.

La figure 3C illustre une étape de dépôt, sur et en contact avec la face supérieure de la structure obtenue à l'issue des étapes de la figure 3B, d'une deuxième couche sacrificielle 303, de préférence de même nature que la couche 301. La couche 303 est par exemple déposée de façon continue sur sensiblement toute la surface du capteur. La face inférieure de la couche 303 est en contact avec la face supérieure des microplanches 103 et des bras de maintien 105a, 105b des pixels, et, avec la face supérieure de la couche 301 dans les régions séparant, en vue de dessus, les microplanches 103 et les bras 105a, 105b des pixels. L'épaisseur de la couche 303 fixe la distance entre la face supérieure de la microplanche 103 et la partie supérieure du capot d'encapsulation du pixel. A titre d'exemple, la couche 303 a une épaisseur comprise entre 1 et 2,5 µm.

La figure 3C illustre en outre la formation des piliers de connexion électrique 121a et 121b du pixel, dans des vias gravés dans les couches sacrificielles 303 et 301 à l'aplomb des plots de connexion 119a et 119b du circuit 102. Les piliers 121a et 121b s'étendent verticalement sur sensiblement toute l'épaisseur des couches sacrificielles 303 et 301, depuis la face supérieure des plots de connexion 119a et 119b du circuit 102, jusqu'à la face supérieure de la couche 303. A titre d'exemple, les piliers de connexion 121a, 121b ont une section de surface comprise entre 0,25 et 1 µm².

La figure 3C illustre de plus la formation d'une couche conductrice 305 localisée sur la surface supérieure des piliers de connexion électrique 121a et 121b. La couche 305 a notamment pour rôle d'empêcher la diffusion du métal des piliers 121a, 121b, par exemple du cuivre ou du tungstène, dans le matériau du capot d'encapsulation du pixel. La couche 305 peut en outre servir de couche d'arrêt de gravure lors d'une étape ultérieure de reprise de contact sur les piliers 121a, 121b. A titre d'exemple, la couche 305 est en nitrure de titane (TiN). La couche 305 a par exemple une épaisseur comprise entre 20 et 80 nm.

La figure 3D illustre une étape postérieure aux étapes de la figure 3C, au cours de laquelle une tranchée périphérique verticale entourant entièrement, en vue de dessus, l'ensemble comprenant la microplanche bolométrique 103, les bras de maintien 105a, 105b et les piliers de connexion électrique 107a, 107b, 121a, 121b, est gravée à partir de la face supérieure de la couche sacrificielle 303 et jusqu'à la face supérieure du circuit 102. La tranchée 307 sépare les éléments 103, 105a, 105b, 107a, 107b, 121a, 121b du pixel des éléments correspondants de pixels voisins. La tranchée 307 est destinée à recevoir les parois latérales du capot d'encapsulation du pixel. Dans cet exemple, une tranchée 307 spécifique est réalisée pour chaque pixel du capteur, c'est-à-dire que deux pixels voisins sont séparés par deux tranchées 307 distinctes.

La figure 3D illustre en outre une étape de dépôt d'une couche 309 transparente pour le rayonnement à détecter sur sensiblement toute la surface supérieure de la structure obtenue après la gravure des tranchées 307, pour former les capots d'encapsulation 111 des pixels du capteur. La couche 309 est par exemple une couche de silicium amorphe de 0,5 à 1 µm d'épaisseur, par exemple de l'ordre de 0,8 µm d'épaisseur. La couche 309 est notamment déposée sur et en contact avec les parois latérales et le fond des tranchées 307, ainsi que sur et en contact avec la face supérieure de la couche sacrificielle 303 ou de la couche barrière 305 en dehors des tranchées 307, de façon à encapsuler hermétiquement, dans chaque pixel, l'ensemble comprenant la microplanche 103, les bras 105a, 105b, et les piliers 107a, 107b, 121a, 121b du pixel.

La figure 3E illustre une étape de gravure, dans la couche 309, de tranchées 311 entourant entièrement, en vue de dessus, chacun des pixels du capteur de façon à individualiser et isoler électriquement les capots d'encapsulation 111 des différents pixels du capteur. En effet, dans le cas où le matériau de la couche 309 est électriquement conducteur, ce qui peut être le cas du silicium amorphe si il est dopé, il est préférable d'isoler électriquement les capots d'encapsulation 111 des différents pixels, de façon que la polarisation appliquée par le circuit de contrôle et de lecture 102 d'un pixel par l'intermédiaire de ses piliers de connexion 121a, 121b, n'entraine pas la circulation d'un courant parasite dans l'ensemble des capots d'encapsulation du capteur. Dans l'exemple représenté, les tranchées 311 sont disposées, en vue de dessus, dans les intervalles séparant les tranchées 307 des pixels voisins du capteur. Les tranchées d'isolation 311 s'étendent verticalement sur toute l'épaisseur de la couche 309, et débouchent sur la face supérieure de la couche sacrificielle 303.

La figure 3E illustre en outre une étape de gravure, dans chaque pixel, d'au moins une ouverture 313 dans la couche 309, à l'intérieur de la zone délimitée (en vue de dessus) par la tranchée 307, c'est-à-dire dans la partie supérieure du capot d'encapsulation 111 du pixel, par exemple en regard d'une partie centrale de la microplanche 103 du pixel. L'ouverture 313 est prévue pour permettre la mise en oeuvre d'une étape ultérieure de retrait des couches sacrificielles 301 et 303 à l'intérieur du capot 111. L'ouverture 313 s'étend verticalement sur toute l'épaisseur de la couche 309, et débouche sur la face supérieure de la couche sacrificielle 303. La largeur de l'ouverture 313, en vue de dessus, est par exemple comprise entre 0,1 et 1 µm.

La figure 3E illustre de plus une étape de gravure d'ouvertures 315 dans la couche 309, localisées en regard des piliers de connexion électrique 121a, 121b de façon à libérer l'accès à la face supérieure de la couche barrière 305.

Les ouvertures 311, 313 et 315 sont par exemple réalisées simultanément lors d'une même étape de gravure.

La figure 3F illustre une étape ultérieure de retrait des couches sacrificielles 303 et 301, par exemple par gravure chimique anisotrope, de façon à libérer la microplanche 103 et les bras de maintien 105a, 105b du pixel.

La figure 3F illustre en outre une étape postérieure au retrait des couches sacrificielles 303 et 301, de dépôt de la couche thermochrome 115 sur et en contact avec la face supérieure du capot d'encapsulation 111, en regard de la microplanche bolométrique 103 du pixel. A titre d'exemple, la couche thermochrome 115 est déposée sur toute la surface supérieure de la structure, puis gravée en regard des ouvertures 311 de façon à isoler électriquement les portions de la couche 115 surmontant les différents pixels du capteur. Selon le type de matériau thermochrome utilisé, un recuit de la couche 115 peut éventuellement être mis en oeuvre pour obtenir la phase cristalline et la température de transition du matériau recherchées. A titre d'exemple, dans le cas d'une couche thermochrome en dioxyde de vanadium (VO₂), le dépôt peut être réalisé à température ambiante par pulvérisation d'une cible de vanadium dans une atmosphère contenant de l'oxygène. Ceci conduit à la formation d'une couche de dioxyde de vanadium amorphe. Un recuit à une température de l'ordre de 350 à 400°C peut ensuite être mis en oeuvre pour cristalliser la couche d'oxyde de vanadium et obtenir les propriétés thermochrome recherchées. La couche thermochrome présente par exemple une épaisseur comprise entre 20 et 100 nm, par exemple entre 20 et 60 nm.

Au niveau des ouvertures 315, la couche thermochrome 115 vient en contact avec la face supérieure de la couche conductrice 305, de façon à connecter électriquement la couche thermochrome 115 aux piliers de connexion 121a et 121b. Dans l'exemple, représenté, le matériau thermochrome de la couche 115 bouche en outre l'ouverture 313 prévue pour le retrait des couches sacrificielles 303 et 301, de façon à assurer la fermeture hermétique de la cavité 113 d'encapsulation du pixel. Le dépôt de la couche thermochrome 115 est par exemple réalisé sous vide ou à une pression inférieure à la pression atmosphérique de façon à mettre sous vide ou à basse pression la cavité d'encapsulation du pixel. On notera que le germanium permet avantageusement d'assurer la double fonction de couche thermochrome et de matériau de fermeture hermétique de l'ouverture 313. A titre de variante, si le matériau thermochrome n'est pas adapté pour boucher hermétiquement l'ouverture 313, une étape intermédiaire de dépôt d'un matériau adapté à boucher l'ouverture 313, par exemple du germanium, ou encore un métal tel que l'aluminium, peut être prévue avant le dépôt de la couche thermochrome 115. Dans le cas ou la couche intermédiaire de bouchage de l'ouverture 113 n'est pas suffisamment transparente pour le rayonnement à détecter, cette dernière peut être déposée de façon localisée uniquement en regard de l'ouverture 113, ou être gravée après dépôt pour n'être conservée qu'en regard de l'ouverture 113.

A l'issue de l'étape de la figure 3F, on obtient un pixel 200 du type décrit en relation avec la figure 2.

La figure 4 illustre une variante du procédé décrit en relation avec les figures 3A, 3B, 3C, 3D, 3E et 3F. La figure 4 est une vue en coupe du pixel obtenu à l'issue du procédé, correspondant à la vue en coupe de la figure 3F.

La variante de réalisation de la figure 4 diffère du procédé décrit précédemment principalement par la façon d'isoler les capots d'encapsulation 111 des différents pixels du capteur.

Le procédé de la figure 4 comprend les mêmes étapes initiales que le procédé décrit précédemment, jusqu'aux étapes de la figure 3C incluses.

Dans la variante de la figure 4, des tranchées verticales 307 de délimitation des pixels sont gravées dans les couches sacrificielles 303 et 301 depuis la face supérieure de la structure. Ces tranchées sont similaires à ce qui a été décrit en relation avec la figure 3D, à ceci près que, dans la variante de la figure 4, deux pixels voisins du capteur sont séparés par une unique tranchée 307. Autrement dit, à la différence de l'exemple de la figure 3D dans lequel on forme une tranchée annulaire 307 spécifique pour chaque pixel du capteur, de sorte que les tranchées 307 de pixels distincts sont disjointes, dans l'exemple de la figure 4, les tranchées 307 ont, en vue de dessus, la forme d'une grille continue s'étendant sur sensiblement toute la surface du capteur et délimitant les différents pixels du capteur.

Les étapes suivantes du procédé de la figure 4 sont similaires à ce qui a été décrit en relation avec les figures 3D et 3E, à ceci près que, à la place de la tranchée 311 de la figure 3E, on grave dans la couche 309, pour chaque pixel, une tranchée annulaire 411 entourant entièrement, en vue de dessus, l'ensemble comprenant la microplanche bolométrique 103, les bras de maintien 105a, 105b et les piliers de connexion électrique 107a, 107b, 121a, 121b du pixel, la tranchée 411 étant située, en vue de dessus, à l'intérieur de la zone délimitée par la tranchée 307 de délimitation du pixel. La tranchée annulaire 411 s'étend verticalement sur toute l'épaisseur de la couche d'encapsulation 309, et débouche sur la face supérieure de la couche sacrificielle 303. La tranchée 411 est ensuite remplie d'un matériau électriquement isolant, par exemple du nitrure de silicium (SiN) ou du nitrure d'aluminium (AIN), de façon à obtenir un cadre ou anneau isolant 413 entourant entièrement une partie centrale supérieure du capot d'encapsulation 111 du pixel, empêchant la circulation de courants parasites entre les capots d'encapsulation des différents pixels du capteur.

Les étapes suivantes sont identiques ou similaires à ce qui a été décrit en relation avec les figures 3E et 3F, la couche thermochrome 115 de chaque pixel étant inscrite, en vue de dessus, à l'intérieur du cadre ou de l'anneau isolant 413 du pixel.

Un avantage de la variante de réalisation de la figure 4 est qu'elle permet, au prix d'une étape supplémentaire de formation du cadre isolant 413 dans l'ouverture 411, de réduire la surface utilisée pour isoler électriquement les capots d'encapsulation 111 et les couches thermochromes 115 des différents pixels du capteur.

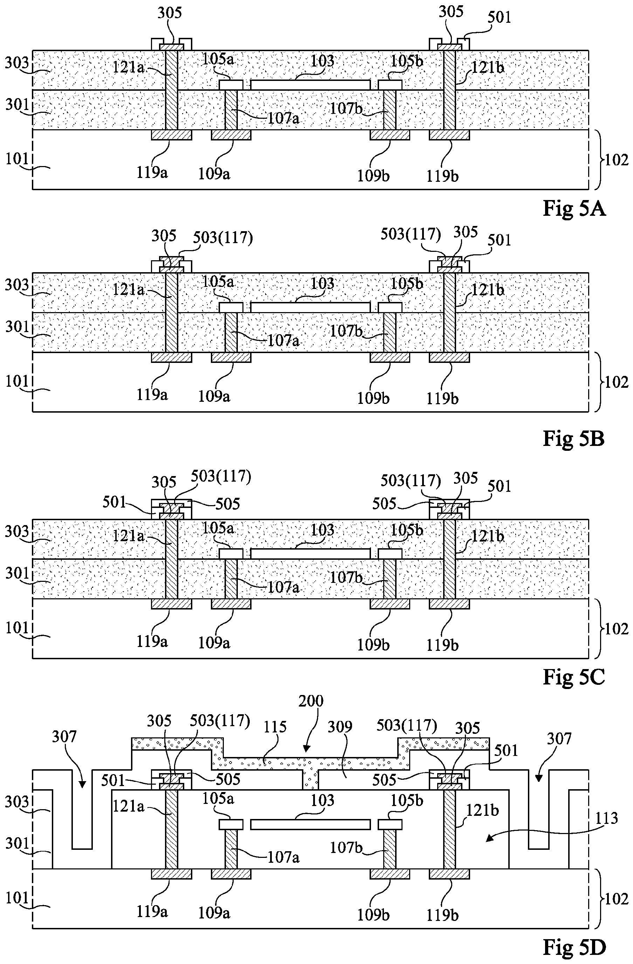

Les figures 5A, 5B, 5C, 5D sont des vues en coupe illustrant des étapes d'un exemple d'un procédé de fabrication d'un capteur de rayonnement du type décrit en relation avec les figures 1A et 1B, c'est-à-dire comportant une résistance chauffante distincte de la couche thermochrome pour commander les transitions à l'état fermé ou à l'état ouvert de la couche thermochrome. Les figures 5A, 5B, 5C et 5D visent plus particulièrement le cas où la résistance chauffante est un cordon conducteur métallique entourant en vue de dessus sans la masquer la microplanche bolométrique 103 du pixel.

Le procédé des figures 5A, 5B, 5C, 5D comprend des éléments communs avec le procédé décrit en relation avec les figures 3A, 3B, 3C, 3D, 3E et 3F et/ou en relation avec la figure 4. Dans la suite, seules les différences avec les procédés des figures 3A, 3B, 3C, 3D, 3E, 3F et 4 seront détaillées.

Le procédé des figures 5A, 5B, 5C et 5D comprend les mêmes étapes initiales que le procédé décrit précédemment, jusqu'aux étapes de la figure 3C incluses.

La figure 5A illustre une étape de dépôt d'une première couche électriquement isolante 501, par exemple en nitrure de silicium (SiN) ou en nitrure d'aluminium (AIN), sur la face supérieure de la structure obtenue à l'issue des étapes de la figure 3C. Des ouvertures sont ensuite gravées dans la couche 501 à l'aplomb des piliers de connexion électrique 121a, 121b, de façon à libérer l'accès à la face supérieure de la couche barrière 305. Lors de cette étape de gravure, la couche 501 est conservée à la périphérie et sur les flancs des portions de la couche 305 surmontant les piliers de connexion électrique 121a, 121b. La couche 501 est en outre conservée sur toute la surface de la structure destinée à recevoir la résistance chauffante 117, de façon que, à la fin du procédé, la résistance chauffante 117 soit entièrement encapsulée dans une gaine électriquement isolante, sauf au niveau de ses régions de connexion électrique à la couche 305. La couche 501 peut être retirée sur le reste de la surface de la structure, et notamment en regard de la microplanche bolométrique 103 du pixel.

La figure 5B illustre une étape ultérieure de dépôt d'une couche conductrice 503 sur la face supérieure de la structure obtenue à l'issue des étapes de la figure 5A, pour former la résistance chauffante 117 du pixel. La couche 503 est par exemple une couche d'aluminium, de titane, ou de nitrure de titane. La couche 503 a par exemple une épaisseur comprise entre 10 et 100 nm, par exemple une épaisseur de l'ordre de 20 nm. A titre d'exemple, la couche 503 est déposée sur toute la surface supérieure de la structure, puis gravée pour conserver uniquement un ruban conducteur 117 disposé sur et en contact avec la face supérieure de la couche isolante 501, entourant, en vue de dessus, l'ensemble comprenant la microplanche bolométrique 103 et les bras de connexion 105a, 105b du pixel, et connecté électriquement aux piliers de connexion 121a, 121b du pixel par l'intermédiaire de la couche barrière 305. La largeur, en vue de dessus, du ruban conducteur 117 est par exemple comprise entre 0,5 et 2 µm, par exemple de l'ordre de 1 µm. A titre d'exemple, en vue de dessus, le ruban conducteur 117 a la forme générale d'un cadre ou anneau carré d'environ 25 µm de côté.

La figure 5C illustre une étape de dépôt d'une deuxième couche électriquement isolante 505, par exemple de même nature que la couche isolante 501, sur la face supérieure de la structure obtenue à l'issue des étapes de la figure 5B. La couche 505 est disposée de façon à recouvrir la face supérieure et les flancs du cordon conducteur formant la résistance chauffante 117, de façon à former avec la couche 501 une gaine isolante d'encapsulation autour de la résistance 117. A titre d'exemple, la couche 505 est d'abord déposée sur toute la surface supérieure de la structure, puis gravée de façon à n'être conservée qu'en regard de la résistance chauffante 117. En particulier, la couche 505 peut être retirée en regard de la microplanche bolométrique 103 du pixel.

Dans une variante, la couche isolante 501 n'est pas gravée à l'étape de la figure 5A, hormis en regard des piliers de connexion électrique 121a, 121b. Les couches 501 et 505 sont ensuite gravées simultanément lors d'une même étape postérieure à la formation du ruban conducteur 117 et au dépôt de la couche 505.

Les étapes suivantes du procédé sont sensiblement identiques à ce qui a été décrit précédemment en relation avec les figures 3D, 3E et 3F et/ou en relation avec la figure 4. On notera toutefois que du fait de l'isolation électrique de la résistance chauffante 117 par les couches diélectriques 501, 505, les étapes d'isolation électrique des capots d'encapsulation des différents pixels sont facultatives.

La figure 5D représente le pixel obtenu à la fin du procédé.

Un avantage des capteurs de rayonnement du type décrit en relation avec les figures 1A, 1B, 2, 3A à 3F, 4 et 5A à 5D est que chaque pixel du capteur peut être protégé individuellement contre un éblouissement, en fonction de l'échauffement mesuré de sa microplanche bolométrique, sans qu'il soit nécessaire d'obturer simultanément tous les pixels du capteur pour mettre en oeuvre la protection.

De plus, à l'état ouvert, toute la surface de l'obturateur en regard de la microplanche bolométrique est transparente pour le rayonnement à détecter, de sorte que l'obturateur n'atténue pas ou peu le rayonnement incident.

On a détaillé ci-dessus des exemples de réalisation dans lesquels chaque pixel comprend une microplanche bolométrique 103 disposée dans une cavité spécifique au pixel, fermée hermétiquement par un capot 111 spécifique au pixel. L'homme du métier saura toutefois prévoir des variantes dans lesquelles plusieurs microplanches bolométriques appartenant à des pixels distincts sont disposées dans une même cavité fermée par un capot d'encapsulation commun à plusieurs pixels.

Par ailleurs, on a décrit en relation avec les figures 1A, 1B, et 5A à 5D, des exemples de réalisation dans lesquels une résistance chauffante 117 est disposée sous la face supérieure du capot d'encapsulation 111 du pixel, pour commander l'ouverture et la fermeture de l'obturateur optique. A titre de variante, la résistance chauffante 117 peut être disposée au-dessus de la face supérieure du capot d'encapsulation 111 du pixel, par exemple sur la face supérieure de la couche thermochrome 115 ou entre le capot d'encapsulation 111 et la couche thermochrome 115.

De plus, on a décrit des exemples de réalisation dans lesquels la couche thermochrome 115 de l'obturateur optique est disposée sur et en contact avec la face supérieure ou face externe du capot d'encapsulation 111 du pixel. A titre de variante, la couche thermochrome 115 peut être disposée à l'intérieur de la cavité 113, en contact avec la face inférieure de la partie supérieure du capot 111.

Par ailleurs, les capteurs décrits en relation avec les figures 1A, 1B, 2, 3A à 3F, 4 et 5A à 5D peuvent comporter des éléments supplémentaires, non détaillés. En particulier, une couche antireflet, par exemple une couche de sulfure de zinc (ZnS), peut être prévue sur la face supérieure des pixels. En outre, une couche réfléchissante pour le rayonnement électromagnétique à détecter peut être prévue sous la microplanche bolométrique 103, sur et en contact avec la face supérieure du circuit de contrôle et de lecture 102 du pixel, de façon à définir une cavité résonnante pour le rayonnement à détecter entre la microplanche bolométrique 103 et la face supérieure du circuit 102.

En outre, on a décrit ci-dessus, en relation avec les figures 1A, 1B, 2, 3A à 3F, 4 et 5A à 5D, des exemples de réalisation dans lesquels chaque pixel du capteur comprend une microplanche suspendue 103 comprenant un microbolomètre. A titre de variante, le microbolomètre peut être remplacé par un autre type d'élément de conversion du rayonnement électromagnétique incident en un signal électrique, par exemple un détecteur thermique ou un détecteur basé sur la conversion du rayonnement incident en énergie thermique, par exemple un thermistor, un détecteur pyroélectrique, ou un détecteur à base de transistors à effet de champ ou à base de diodes PN.

### Deuxième mode de réalisation - protection passive sur microplanche

La figures 6 est une vue en coupe simplifiée d'un exemple d'un pixel 600 d'un capteur de rayonnement selon un deuxième mode de réalisation. Le pixel 600 de la figure 6 comprend des éléments communs avec les pixels décrits précédemment. Dans la suite, seules les différences par rapport aux exemples du premier mode de réalisation seront détaillées.

Comme dans les exemples décrits précédemment, le pixel 600 de la figure 6 est formé dans et sur un substrat semiconducteur 101, par exemple en silicium, et comprend un circuit électronique de lecture et de contrôle 102 formé dans et sur le substrat 101. De plus, comme dans les exemples précédents, le pixel 600 comprend une microplanche 103 suspendue au-dessus du circuit 102 par des bras d'isolation thermique, deux bras 105a et 105b dans l'exemple représenté, et des piliers conducteurs verticaux 107a, 107b reliés à des plots de connexion 109a, 109b du circuit 102. Le pixel 600 peut en outre comprendre, comme dans les exemples précédents, un capot 111 transparent au rayonnement à détecter, reposant sur la face supérieure du circuit de contrôle 102 et délimitant, avec la face supérieure du circuit de contrôle 102, une cavité ou enceinte hermétique 113 dans laquelle est située la microplanche suspendue 103. La cavité 113 peut être mise sous vide ou à une pression inférieure à la pression atmosphérique de façon à renforcer l'isolation thermique de la microplanche 103.

A la différence des exemples du premier mode de réalisation, le pixel 600 de la figure 6 ne comprend pas un obturateur optique actif et ne comprend en particulier pas une couche thermochrome revêtant une face du capot transparent 111 en regard de la microplanche 103 et connectée au circuit de contrôle et de lecture 102 du pixel. Plus particulièrement, dans l'exemple de la figure 6, le pixel 600 ne comprend pas les piliers de connexion 121a, 121b, les plots de connexion 119a, 119b, la résistance chauffante 117, et la couche thermochrome 115 des exemples du premier mode de réalisation.

La microplanche 103 du pixel 600 comprend un élément de conversion du rayonnement électromagnétique incident en énergie thermique. Dans l'exemple représenté, la microplanche 103 est une microplanche bolométrique, c'est-à-dire qu'elle comprend un absorbeur 601, par exemple sous la forme d'une couche conductrice, adapté à convertir un rayonnement électromagnétique incident en énergie thermique, et une thermistance 603 permettant de mesurer la température de l'absorbeur. L'absorbeur 601 se présente par exemple sous la forme d'une couche s'étendant sur sensiblement toute la surface de la microplanche. A titre d'exemple, l'absorbeur est en nitrure de titane (TiN). La thermistance 603 est réalisée en un matériau appelé ci-après matériau thermomètre, dont la résistivité électrique varie de façon significative en fonction de la température, par exemple du silicium amorphe ou de l'oxyde de vanadium. A titre d'exemple, la thermistance 603 se présente sous la forme d'une couche revêtant sensiblement toute la surface de la microplanche 103. Deux extrémités de la thermistance sont connectées électriquement au circuit de contrôle du pixel, par des liaisons électriques non détaillées sur la figure 6, passant par les bras 105a, 105b et les piliers 107a, 107b de suspension de la microplanche.

Selon un aspect du mode de réalisation de la figure 6, la microplanche 103 du pixel 600 comprend un obturateur optique passif comportant une couche 605 en un matériau thermochrome, revêtant l'élément de conversion du rayonnement incident en énergie thermique du pixel, à savoir l'absorbeur 601 dans cet exemple. Par obturateur passif, on entend ici que l'obturateur n'est pas commandé électriquement par le circuit de contrôle et de lecture 102 du pixel. Dans le mode de réalisation de la figure 6, la couche thermochrome 605 est couplée thermiquement à l'élément de conversion du rayonnement incident en énergie thermique, et c'est la chaleur produite par l'élément de conversion qui, lorsqu'elle devient trop élevée, provoque directement une modification des propriétés optiques de la couche thermochrome, de façon diminuer son coefficient de transmission pour le rayonnement incident. Dans cet exemple, la couche thermochrome 605 est disposée entre l'absorbeur 601 et la thermistance 603. La couche thermochrome 605 est choisie pour avoir un coefficient de réflexion croissant en fonction de la température. Plus particulièrement, la couche thermochrome 605 est choisie pour être sensiblement transparente pour le rayonnement à détecter en dessous d'une température de transition, et pour présenter un coefficient de réflexion pour le rayonnement à détecter relativement élevé au-dessus de sa température de transition. La température de transition de la couche thermochrome est de préférence supérieure à la température maximale que peut atteindre la microplanche 103 en fonctionnement normal, et inférieure à la température maximale que peut supporter la microplanche 103 avant dégradation du pixel. A titre d'exemple, la température de transition de la couche thermochrome est comprise entre 60 et 180°C. La variation du coefficient de réflexion ou de transmission de la couche thermochrome autour de la température de transition est de préférence relativement abrupte, par exemple supérieure à 2,5% par degré pour une longueur d'onde de 10 µm. En cas d'éblouissement du pixel, l'obturateur se ferme automatiquement sous l'effet de l'échauffement de la microplanche. Une partie du rayonnement électromagnétique incident est alors réfléchie par la couche 605, et n'est donc plus absorbée par l'élément de conversion du pixel. Ceci permet d'éviter ou de limiter une dégradation de la microplanche bolométrique du pixel. Lorsque la température de la couche 605 redescend en dessous de sa température de transition, l'obturateur se rouvre.

Le matériau de la couche thermochrome 605 est par exemple un matériau à changement de phase, par exemple un oxyde métallique cristallisé présentant une phase isolante transparente pour le rayonnement à détecter en dessous de sa température de transition, et une phase métallique réfléchissante pour le rayonnement à détecter au-dessus de sa température de transition. Le matériau thermochrome est par exemple du dioxyde de vanadium (VO₂) cristallisé, présentant une température de transition de l'ordre de 68°C. A titre de variante, le matériau thermochrome est du dioxyde de vanadium cristallisé et dopé par des cations de basse valence, par exemple Al3+, Cr3+ ou Ti4+, de façon à augmenter sa température de transition. Plus généralement, selon la température de transition recherchée, d'autres oxydes de vanadium peuvent être utilisés, par exemple du V₃O₅. A titre de variante, le matériau thermochrome de la couche 605 est du Ti₃O₅, du Ti₂O₃, ou du SmNiO₃. A titre de variante, le matériau thermochrome de la couche 605 est un nickelate de terre rare de composition générale RNiO₃, où R désigne une terre rare ou un alliage binaire de terre rare, par exemple un composé de type SmₓNd₁₋ₓNiO₃ ou EuₓSm₁₋ₓNiO₃. A titre de variante, le matériau thermochrome de la couche 605 est du Ag₂S ou du FeS.

Les figures 7A, 7B, 7C, 7D, 7E et 7F sont des vues en coupe illustrant des étapes d'un exemple d'un procédé de fabrication d'un capteur de rayonnement du type décrit en relation avec la figure 6. Les figures 7A, 7B, 7C, 7D, 7E et 7F illustrent plus particulièrement la réalisation d'un unique pixel 600 du capteur, étant entendu que, en pratique, une pluralité de pixels identiques ou similaires peuvent être formés simultanément dans et sur un même substrat semiconducteur 101.

La figure 7A illustre une étape de fabrication du circuit de contrôle et de lecture 102 du pixel 600, dans et sur le substrat 101, par exemple en technologie CMOS. Sur la figure 7A, seuls les plots de connexion électrique 109a et 109b du circuit 102, affleurant au niveau de la face supérieure du circuit, ont été représentés.

La figure 7A illustre en outre une étape optionnelle de formation, sur la face supérieure du circuit 102, d'une couche réfléchissante 701, par exemple une couche d'aluminium, d'argent ou de cuivre. Ce réflecteur, pouvant aussi être prévu de façon optionnelle dans les exemples des figures 1A, 1B, 2, 3A à 3F, 4 et 5A à 5D, permet de définir une cavité résonante pour le rayonnement à détecter, entre la microplanche 103 et la face supérieure du circuit 102, de façon à augmenter l'absorption du rayonnement incident par la microplanche 103. A titre d'exemple, la couche 701 est d'abord déposée sur toute la surface du capteur, puis gravée pour être conservée seulement en regard de la future microplanche 103 du pixel.

La figure 7A illustre de plus une étape de dépôt d'une couche sacrificielle 301 sur et en contact avec la face supérieure du circuit 102 et, le cas échéant, du réflecteur 701. La couche 301 est par exemple déposée de façon continue sur sensiblement toute la surface du capteur. A titre d'exemple, la couche 301 est en polyimide ou en oxyde de silicium. L'épaisseur de la couche 301 fixe la distance entre la face supérieure du circuit 102 et/ou du réflecteur 701 et la microplanche bolométrique 103 du pixel. A titre d'exemple, la couche 301 a une épaisseur comprise entre 1 et 5 µm, par exemple de l'ordre de 2,5 µm.

La figure 7A illustre en outre la formation des piliers de connexion électrique 107a et 107b du pixel, dans des vias gravés dans la couche sacrificielle 301 à l'aplomb des plots de connexion 109a et 109b du circuit 102. Les piliers 107a et 107b s'étendent verticalement sur sensiblement toute l'épaisseur de la couche 301, depuis la face supérieure des plots de connexion 109a et 109b du circuit 102, jusqu'à la face supérieure de la couche 301.

La figure 7A illustre de plus une étape postérieure à la formation des piliers 107a et 107b, de dépôt, sur la face supérieure de la couche sacrificielle 301, d'une première couche électriquement isolante 703, par exemple en nitrure de silicium (SiN), en nitrure d'aluminium (AlN) ou en carbure de silicium (SiC), servant de support à la construction de la microplanche 103 et des bras d'isolation thermique 105a, 105b du pixel. La couche 703 est par exemple déposée de façon continue sur sensiblement toute la surface du capteur, puis gravée localement à l'aplomb des piliers 107a et 107b de manière à former des ouvertures 704a, 704b en regard d'une partie centrale de la face supérieure des piliers 107a, 107b respectivement, permettant la reprise d'un contact électrique sur la face supérieure des piliers.

La figure 7B illustre une étape ultérieure de dépôt, sur la face supérieure de la couche isolante 703 et sur la face supérieure des piliers 107a, 107b dégagée au niveau des ouvertures 704a, 704b, d'une couche 601 en un matériau absorbant pour le rayonnement à détecter, pour former l'absorbeur du microbolomètre du pixel. La couche 601 est par exemple déposée de façon continue sur sensiblement toute la surface du capteur. En particulier, dans l'exemple représenté, la couche 601 est en contact avec la face supérieure de la couche isolante 703, et avec une partie de la face supérieure des piliers de connexion électrique 107a, 107b.

La figure 7B illustre en outre une étape de gravure d'une tranchée 705 dans la couche 601, visant à séparer l'absorbeur en deux portions disjointes 601-a et 601-b dans la future microplanche bolométrique 103 du pixel. En effet, dans cet exemple, l'absorbeur 601 est en un matériau électriquement conducteur, par exemple du nitrure de titane, et est utilisé non seulement pour sa fonction d'absorbeur, mais aussi comme conducteur électrique pour relier électriquement les extrémités de la thermistance du pixel au circuit 102, par l'intermédiaire des piliers de connexion électrique 107a, 107b. Il convient donc de séparer l'absorbeur en deux portions ou électrodes disjointes, l'une (la portion 601-a) connectée au pilier 107a et à une première extrémité de la thermistance du pixel, et l'autre (la portion 601-b) connectée au pilier 107b et à une deuxième extrémité de la thermistance du pixel. La tranchée 705 s'étend verticalement depuis la face supérieure jusqu'à la face inférieure de la couche 601, et s'interrompt sur la face supérieure de la couche isolante 703. En vue de dessus, la tranchée 705 s'étend par exemple sur toute la largeur de la future microplanche bolométrique 103, dans une partie centrale de la microplanche.

La figure 7B illustre de plus une étape de dépôt, sur la face supérieure de la structure obtenue après la formation de la tranchée 705, d'une deuxième couche électriquement isolante 707, par exemple de même nature que la couche 703, recouvrant la face supérieure de la couche 601, ainsi que les parois latérales et le fond des tranchées 705. La couche 707 est par exemple déposée de façon continue sur sensiblement toute la surface du capteur.

La figure 7C illustre une étape de dépôt de la couche thermochrome 605 sur et en contact avec la face supérieure de la couche isolante 707. A titre d'exemple, la couche thermochrome 605 est déposée de façon continue sur toute la surface du capteur, puis gravée pour n'être conservée que sur la microplanche 103 de chaque pixel. Dans chaque pixel, deux ouvertures localisées 709a et 709b sont en outre gravées dans la couche thermochrome 605, respectivement en regard de la portion 601-a et en regard de la portion 601-b de l'absorbeur 601, en vue d'une étape ultérieure de reprise de contact électrique sur les portions 601-a et 601-b de l'absorbeur, pour connecter la thermistance du pixel au circuit de lecture 102. Les ouvertures 709a et 709b sont par exemple disposées respectivement au voisinage de deux bords opposés de la microplanche. Dans l'exemple représenté, les ouvertures 709a et 709b s'étendent sur toute l'épaisseur de la couche thermochrome 605, et débouchent sur la face supérieure de la couche isolante 707. Selon le type de matériau thermochrome utilisé, un recuit de la couche 605 peut éventuellement être mis en oeuvre pour obtenir la phase cristalline et la température de transition du matériau recherchées. A titre d'exemple, dans le cas d'une couche thermochrome en dioxyde de vanadium (VO₂), le dépôt peut être réalisé à température ambiante par pulvérisation d'une cible de vanadium dans une atmosphère contenant de l'oxygène, puis un recuit à une température de l'ordre de 350 à 400°C peut être mis en oeuvre pour cristalliser la couche d'oxyde de vanadium et obtenir les propriétés thermochrome recherchées. La gravure de la couche thermochrome 605 peut être réalisée avant ou après le recuit. La couche thermochrome présente par exemple une épaisseur comprise entre 20 et 100 nm, par exemple entre 20 et 60 nm.

La figure 7C illustre de plus une étape postérieure à la gravure et au recuit de la couche thermochrome 605, de dépôt d'une troisième couche électriquement isolante 711, par exemple de même nature que la couche 703 et/ou que la couche 707, sur la surface supérieure de la structure. La couche 711 est par exemple déposée de façon continue sur sensiblement toute la surface du capteur. Dans l'exemple représenté, la couche isolante 711 s'étend sur et en contact avec la face supérieure et avec les flancs de la couche thermochrome 605, et sur et en contact avec la face supérieure de la couche isolante 707. La couche isolante 711 s'étend en outre sur et en contact avec les parois latérales et le fond des ouvertures 709a, 709b formées dans la couche thermochrome.

La figure 7D illustre une étape ultérieure de gravure localisée des couches isolantes 711 et 707 au fond des ouvertures 709a, 709b, de façon à libérer l'accès à la face supérieure des portions 601-a, 601-b de l'absorbeur 601.

La figure 7E illustre une étape de dépôt d'une couche 603 du matériau thermomètre, par exemple du silicium amorphe ou de l'oxyde de vanadium, sur la face supérieure de la structure obtenue à l'issue de l'étape de la figure 7D, pour réaliser la thermistance du pixel. La couche 603 est par exemple déposée de façon continue sur sensiblement toute la surface du capteur, puis gravée pour être conservée seulement sur la microplanche 103 du pixel. La couche 603 est notamment déposée à l'intérieur des ouvertures 709a, 709b de façon que la thermistance 603 soit connectée d'une part (par une première extrémité) au plot 109a du circuit 102 par l'intermédiaire de la portion 601-a de l'absorbeur 601 et du pilier de connexion 107a, et d'autre part (par une deuxième extrémité) au plot 109b du circuit 102 par l'intermédiaire de la portion 601-b de l'absorbeur 601 et du pilier de connexion 107b.

La figure 7E illustre de plus une étape de dépôt d'une quatrième couche électriquement isolante 713, par exemple de même nature que les couches 703, 707 et/ou 711, sur la surface supérieure de la structure. La couche 713 est par exemple déposée de façon continue sur sensiblement toute la surface du capteur, et notamment sur et en contact avec la face supérieure et les flancs de la thermistance 603.

La figure 7F illustre une étape ultérieure de gravure de l'empilement formé par les couches 703, 601, 707, 711 et 713 de façon à délimiter ou individualiser la microplanche 103 et les bras 105a, 105b du pixel. Lors de cette étape, l'empilement 703-601-707-711-713 est par exemple retiré partout sauf au niveau des microplanches 103 et des bras 105a, 105b des pixels du capteur.

Le procédé peut ensuite se poursuivre de façon classique, soit directement par le retrait de la couche sacrificielle 301 pour libérer la microplanche 103 et les bras 105a, 105b du pixel, soit, si l'on souhaite former un capot d'encapsulation, par le dépôt d'une deuxième couche sacrificielle puis par la formation du capot d'encapsulation selon des méthodes du type décrit en relation avec les figures 3C à 3F.

Dans l'exemple décrit en relation avec les figures 7A à 7F, lorsqu'un recuit de cristallisation de la couche 605 est réalisé pour obtenir les propriétés thermochrome recherchées, ce recuit est réalisé avant le dépôt de la couche thermomètre 603. Ceci permet que les propriétés thermomètre de la couche 603 ne soient pas dégradées par le recuit. En particulier, dans le cas où la couche thermochrome 605 et la couche thermomètre 603 sont toutes les deux en oxyde de vanadium, ceci permet d'obtenir, dans la même structure, du dioxyde de vanadium cristallin dans la couche thermochrome 605, et un oxyde de vanadium présentant des propriétés cristallines différentes, optimisé pour ses propriétés de thermomètre, dans la couche thermomètre 603.

A titre de variante, dans le cas où le matériau thermomètre peut supporter sans dégradation significative le recuit de cristallisation du matériau thermochrome, ce qui est le cas par exemple du silicium amorphe (dans le cas d'une couche thermochrome en dioxyde de vanadium), la couche thermochrome 605 peut être formée au-dessus de la couche thermomètre 603.

Par ailleurs, on peut prévoir de déposer le matériau thermochrome au-dessus du matériau thermomètre, puis de cristalliser le matériau thermochrome par recuit thermique rapide de type RTA, par exemple au moyen d'une lampe ou d'un laser irradiant la face supérieure de l'assemblage, de façon à limiter l'échauffement de la couche thermomètre lors du recuit. Dans ce cas, une couche tampon peut en outre être prévue entre la couche thermomètre et la couche thermochrome, pour limiter l'échauffement de la couche thermomètre lors du recuit.

Dans une autre variante de réalisation, la couche thermochrome 605 peut être disposée du côté de la face inférieure de l'absorbeur 601, c'est-à-dire du côté de l'absorbeur opposé à la face d'éclairement du pixel. Cette configuration, bien que moins avantageuse, permet aussi de limiter l'absorption du rayonnement électromagnétique incident lors de la fermeture de l'obturateur, dans la mesure où l'obturateur limite alors l'absorption du flux réfléchi par la couche 701.

On notera par ailleurs que dans le cas où le matériau thermochrome est un oxyde métallique cristallin présentant une phase isolante et une phase métallique, la transition entre les deux phases peut s'accompagner d'une variation significative de la densité de la couche 605. Ceci peut induire des contraintes susceptibles de déstabiliser la microplanche. Pour limiter ces contraintes, des structurations adaptées de la couche thermochrome 605 peuvent être prévues. Par exemple, dans chaque pixel du capteur, la couche thermochrome 605 du pixel peut être une couche discontinue constituée d'une pluralité de régions disjointes séparées par des tranchées relativement étroites, par exemple n'occupant pas plus de 20% de la surface de la microplanche.

De préférence, pour favoriser le couplage thermique entre l'absorbeur 601 et la couche thermochrome 605, la distance entre l'absorbeur 601 et la couche thermochrome 605 est relativement faible, par exemple inférieure à 20 nm. A titre d'exemple, la couche isolante 707, faisant interface entre l'absorbeur 601 et la couche thermochrome 605 (la couche isolante 707 a sa face inférieure en contact avec la face supérieure de l'absorbeur 601 et sa face supérieure en contact avec la face inférieure de la couche thermochrome 605), présente une épaisseur comprise entre 1 et 20 nm, par exemple de l'ordre de 10 nm.

La figure 7bis est une vue en coupe illustrant une variante de réalisation du capteur de rayonnement décrit en relation avec les figures 7A à 7F, dans laquelle l'absorbeur 601 est en contact avec la couche thermochrome 605, de façon à maximiser le couplage thermique entre l'absorbeur 601 et la couche thermochrome 605.

Le capteur de rayonnement de la figure 7bis, et son procédé de fabrication, comprennent des éléments communs avec le capteur de rayonnement et le procédé de fabrication décrits en relation avec les figures 7A à 7F. Dans la suite, seules les différences entre les deux exemples de réalisation seront détaillées.

La fabrication du capteur de la figure 7bis est identique ou similaire à celle du capteur des figures 7A à 7F, jusqu'au dépôt de la couche conductrice d'absorption 601.

Comme dans l'exemple des figures 7A à 7F, une tranchée 705 est ensuite gravée dans la couche 601 pour séparer l'absorbeur 601 en deux portions disjointes 601-a et 601-b. Toutefois, à la différence de l'exemple des figures 7A à 7F où, vu de dessus, les portions 601-a et 601-b de l'absorbeur sont symétriques par rapport à la tranchée 705, dans l'exemple de la figure 7bis, les portions 601-a et 601-b de l'absorbeur sont asymétriques par rapport à la tranchée 705. Plus particulièrement, dans cet exemple, vu de dessus, la surface de la portion 601-a de l'absorbeur est supérieure, par exemple au moins trois fois supérieure, à la surface de la portion 601-b de l'absorbeur.

Comme dans l'exemple des figures 7A à 7F, une couche électriquement isolante 707 est déposée sur la face supérieure de la structure obtenue après la formation de la tranchée 705, c'est-à-dire sur la face supérieure de la couche 601, ainsi que sur les parois latérales et sur le fond de la tranchée 705. Dans l'exemple de la figure 7bis, la couche 707 est ensuite localement retirée pour exposer tout ou partie de la face supérieure de la portion 601-a de l'absorbeur et/ou tout ou partie de la face supérieure de la portion 601-b de l'absorbeur. Dans cet exemple, la couche 707 n'est conservée que dans la tranchée 705 et, éventuellement, sur une partie de la face supérieure de la portion 601-a et/ou de la portion 601-b de l'absorbeur, au voisinage immédiat de la tranchée 705.

La couche thermochrome 605 est ensuite déposée de façon identique ou similaire à ce qui a été décrit précédemment, à la différence près que, dans l'exemple de la figure 7bis, la couche thermochrome 605 vient en contact avec la face supérieure des portions 601-a et 601-b de l'absorbeur.

De plus, dans l'exemple de la figure 7bis, pour éviter que la couche thermochrome 605 ne court-circuite les portions 601-a et 601-b de l'absorbeur, une tranchée traversante 706, débouchant sur la face supérieure de la couche isolante 707, est formée dans la couche thermochrome 605 à l'aplomb de la tranchée 705, de façon à séparer la couche thermochrome 605 en deux parties disjointes 605-a et 605-b, respectivement en contact avec la portion 601-a de l'absorbeur et avec la portion 601-b de l'absorbeur. La tranchée 706 est par exemple formée en même temps que les ouvertures de reprise de contact 709a et 709b (figure 7C).

Le procédé peut ensuite se poursuivre de façon identique ou similaire à ce qui a été décrit en relation avec les figures 7A à 7F.

Plus généralement, d'autres procédés de fabrication peuvent être envisagés permettant de mettre en contact la couche thermochrome 605 avec tout ou partie de la face supérieure de l'absorbeur 601. A titre d'exemple, la couche thermochrome peut être en contact avec une seule des deux portions 601-a et 601-b de l'absorbeur, de préférence la plus grande des deux portions (la portion 601-a dans l'exemple de la figure 7bis) pour favoriser le couplage thermique, et être isolée électriquement de l'autre portion de l'absorbeur par la couche 707. Ceci permet de se passer de la tranchée de séparation 706 de l'exemple de la figure 7bis.

Un avantage des capteurs de rayonnement du type décrit en relation avec les figures 6, 7A à 7F, et 7bis est que chaque pixel du capteur est protégé individuellement contre un éblouissement.

De plus, à l'état ouvert, toute la surface de l'obturateur en regard de l'élément de conversion du rayonnement incident en énergie thermique est transparente pour le rayonnement à détecter, de sorte que l'obturateur n'atténue pas ou peu le rayonnement incident.

Un autre avantage du mode de réalisation des figures 6, 7A à 7F, et 7bis est que la protection anti-éblouissement obtenue est une protection passive, fonctionnant même en l'absence d'alimentation électrique du capteur.

On a détaillé ci-dessus des exemples de réalisation dans lesquels chaque pixel comprend une microplanche suspendue 103 disposée dans une cavité spécifique au pixel, fermée hermétiquement par un capot 111 spécifique au pixel. L'homme du métier saura toutefois prévoir des variantes dans lesquelles plusieurs microplanches suspendues appartenant à des pixels distincts sont disposées dans une même cavité fermée par un capot d'encapsulation commun à plusieurs pixels.

De plus, le mode de réalisation des figures 6, 7A à 7F, et 7bis est compatible avec un capteur dans lequel les microplanches suspendues 103 ne sont pas surmontées par un capot d'encapsulation.

En outre, on a décrit ci-dessus, en relation avec les figures 6, 7A à 7F, et 7bis, des exemples de réalisation dans lesquels chaque pixel du capteur comprend une microplanche suspendue 103 comprenant un microbolomètre. A titre de variante, le microbolomètre peut être remplacé par un autre type d'élément de conversion du rayonnement électromagnétique incident en un signal électrique, par exemple un détecteur thermique ou un détecteur basé sur la conversion du rayonnement incident en énergie thermique, par exemple un thermistor, un détecteur pyroélectrique, ou un détecteur à base de transistors à effet de champ ou à base de diodes PN.

### Troisième mode de réalisation - protection passive sur bras

La figures 8 est une vue en coupe simplifiée d'un exemple d'un pixel 800 d'un capteur de rayonnement selon un troisième mode de réalisation. Le pixel 800 de la figure 8 comprend des éléments communs avec les pixels décrits précédemment. Dans la suite, seules les différences par rapport aux exemples des premier et deuxième modes de réalisation seront détaillées.

Comme dans les exemples décrits précédemment, le pixel 800 de la figure 8 est formé dans et sur un substrat semiconducteur 101, par exemple en silicium, et comprend un circuit électronique de lecture et de contrôle 102 formé dans et sur le substrat 101. De plus, comme dans les exemples précédents, le pixel 800 comprend une microplanche 103 suspendue au-dessus du circuit 102 par des bras d'isolation thermique, deux bras 105a et 105b dans l'exemple représenté, et des piliers conducteurs verticaux 107a, 107b reliés à des plots de connexion 109a, 109b du circuit 102. Le pixel 800 peut en outre comprendre, comme dans les exemples précédents, un capot 111 transparent au rayonnement à détecter, reposant sur la face supérieure du circuit de contrôle 102 et délimitant, avec la face supérieure du circuit de contrôle 102, une cavité ou enceinte hermétique 113 dans laquelle est située la microplanche suspendue 103. La cavité 113 peut être mise sous vide ou à une pression inférieure à la pression atmosphérique de façon à renforcer l'isolation thermique de la microplanche 103.

A la différence des exemples du premier mode de réalisation, le pixel 800 de la figure 8 ne comprend pas un obturateur optique actif et ne comprend en particulier pas une couche thermochrome revêtant une face du capot transparent 111 en regard de la microplanche 103 et connectée au circuit de contrôle et de lecture 102 du pixel. Plus particulièrement, dans l'exemple de la figure 8, le pixel 800 ne comprend pas les piliers de connexion 121a, 121b, les plots de connexion 119a, 119b, la résistance chauffante 117, et la couche thermochrome 115 des exemples du premier mode de réalisation.

De plus, à la différence des exemples du deuxième mode de réalisation, le pixel 800 de la figure 8 ne comprend pas un obturateur optique passif constitué par une couche thermochrome intégrée à la microplanche 103.

La microplanche 103 du pixel 800 comprend un élément de conversion du rayonnement électromagnétique incident en énergie thermique. Dans l'exemple représenté, la microplanche 103 est une microplanche bolométrique différant de la microplanche 103 du pixel 600 de la figure 6 principalement en ce qu'elle ne comprend pas la couche thermochrome 605. Ainsi, la microplanche 103 du pixel 800 de la figure 8 comprend un absorbeur 601, par exemple identique ou similaire à celui de la microplanche 103 du pixel de la figure 6, et une thermistance 603 couplée thermiquement à l'absorbeur 601, par exemple identique ou silimaire à celle de la microplanche 103 du pixel de la figure 6. Deux extrémités de la thermistance sont connectées électriquement au circuit de contrôle du pixel, par des liaisons électriques passant par les bras 105a, 105b et les piliers 107a, 107b de suspension de la microplanche.

Selon un aspect du mode de réalisation de la figure 8, au moins un des bras d'isolation thermique du pixel 800 comprend une couche 801 en un matériau à changement de phase présentant, en dessous d'une température de transition, une conductivité thermique relativement faible, et, au-dessus de la température de transition, une conductivité thermique relativement élevée, c'est-à-dire supérieure à sa conductivité thermique en dessous de la température de transition. Dans l'exemple représenté, la couche 801 est présente dans les deux bras de suspension 105a, 105b du pixel, et n'est pas présente sur la microplanche 103. La variation de la conductivité thermique du matériau à changement de phase autour de la température de transition est de préférence relativement abrupte, par exemple supérieure à 0,08 W/m.K par degré. On obtient ainsi une protection anti-éblouissement passive du pixel, dont le fonctionnement est le suivant. En fonctionnement normal, le matériau de la couche 801 présente une conductivité thermique relativement faible, de sorte que la résistance thermique entre la microplanche 103 et le substrat est relativement élevée, ce qui est favorable à la mise en oeuvre de mesures du rayonnement électromagnétique incident. En cas d'échauffement excessif de la microplanche 103 lié à un éblouissement du pixel, les bras d'isolation thermique 105a, 105b du pixel s'échauffent également, jusqu'à atteindre la température de transition de la couche 801. La résistance thermique du ou des bras comportant le matériau à changement de phase chute alors brusquement, ce qui provoque l'évacuation vers le substrat 101 d'une partie de la chaleur accumulée dans la microplanche 103. Ceci permet d'éviter ou de limiter une dégradation de la microplanche bolométrique du pixel. Lorsque la température des bras d'isolation thermique redescend en dessous de la température du matériau à changement de phase, ce dernier retrouve une conductivité thermique relativement faible, et le pixel peut de nouveau fonctionner normalement.

La température de transition de la couche 801 est de préférence supérieure à la température maximale que peut atteindre la microplanche 103 en fonctionnement normal, et inférieure à la température maximale que peut supporter la microplanche 103 avant dégradation du pixel. A titre d'exemple, la température de transition de la couche 801 est comprise entre 60 et 180°C. Le matériau de la couche 801 est par exemple un oxyde métallique cristallisé présentant, en dessous de sa température de transition, une phase isolante de conductivité thermique relativement faible, et, au-dessus de sa température de transition, une phase métallique de conductivité thermique relativement élevée. Le matériau de la couche 801 est par exemple du dioxyde de vanadium (VO₂) cristallisé, présentant une température de transition de l'ordre de 68°C. A titre de variante, le matériau de la couche 801 est du dioxyde de vanadium cristallisé et dopé par des cations de basse valence, par exemple Al3+, Cr3+ ou Ti4+, de façon à augmenter sa température de transition. Plus généralement, selon la température de transition recherchée, d'autres oxydes de vanadium peuvent être utilisés, par exemple du V₃O₅. A titre d'exemple, la couche 801 présente une épaisseur comprise entre 10 et 100 nm, par exemple de l'ordre de 50 nm.

Les figures 9A, 9B, 9C, 9D, 9E, 9F et 9G sont des vues en coupe illustrant des étapes d'un exemple d'un procédé de fabrication d'un capteur de rayonnement du type décrit en relation avec la figure 8. Les figures 9A, 9B, 9C, 9D, 9E, 9F et 9G illustrent plus particulièrement la réalisation d'un unique pixel 800 du capteur, étant entendu que, en pratique, une pluralité de pixels identiques ou similaires peuvent être formés simultanément dans et sur un même substrat semiconducteur 101.

La figure 9A illustre une étape de fabrication du circuit de contrôle et de lecture 102 du pixel 800, dans et sur le substrat 101, par exemple en technologie CMOS. Sur la figure 9A, seuls les plots de connexion électrique 109a et 109b du circuit 102, affleurant au niveau de la face supérieure du circuit, ont été représentés.

La figure 9A illustre en outre une étape optionnelle de formation, sur la face supérieure du circuit 102, d'une couche réfléchissante 701 identique ou similaire à la couche 701 de l'exemple de la figure 7A.

La figure 9A illustre de plus une étape de dépôt d'une couche sacrificielle 301 sur et en contact avec la face supérieure du circuit 102 et/ou du réflecteur 701. La couche 301 est par exemple identique ou similaire à la couche 301 de la figure 7A.

La figure 9A illustre en outre une étape de formation des piliers de connexion électrique 107a et 107b du pixel, dans des vias gravés dans la couche 301 à l'aplomb des plots de connexion 109a et 109b du circuit 102. Les piliers 107a et 107b s'étendent verticalement sur sensiblement toute l'épaisseur de la couche 301, depuis la face supérieure des plots de connexion 109a et 109b du circuit 102, jusqu'à la face supérieure de la couche 301.

La figure 9A illustre en outre une étape de dépôt, sur la face supérieure de la couche sacrificielle 301 et sur la face supérieure des piliers 107a, 107b, d'une première couche 801' en le même matériau que celui de la future couche 801 du pixel. La fonction de la couche 801' est principalement d'équilibrer les contraintes mécaniques de l'assemblage lors de la réalisation de la couche 801. Dans cet exemple, la couche 801' n'est pas recuite à l'étape de la figure 9A, et ne sera éventuellement recuite qu'ultérieurement, en même temps que la couche 801, dans le cas où la couche 801 du pixel est en un matériau nécessitant un recuit pour obtenir la phase cristalline et la température de transition recherchées. A titre d'exemple, la couche 801' est une couche de dioxyde de vanadium amorphe déposée à température ambiante par pulvérisation d'une cible de vanadium dans une atmosphère contenant de l'oxygène.

La figure 9A illustre de plus une étape de dépôt, sur la face supérieure de la couche 801', d'une première couche électriquement isolante 803, par exemple en nitrure de silicium (SiN), en nitrure d'aluminium (AlN) ou en carbure de silicium (SiC) .

Les couches 801' et 803 sont par exemple déposées de façon continue sur sensiblement toute la surface du capteur, puis gravées localement à l'aplomb des piliers 107a et 107b de manière à former des ouvertures 804a, 804b en regard d'une partie centrale de la face supérieure des piliers 107a, 107b respectivement, permettant la reprise d'un contact électrique sur la face supérieure des piliers.

La figure 9B illustre une étape de dépôt, sur la face supérieure de la couche isolante 803, et sur le fond et sur les flancs des ouvertures 804a, 804b, d'une couche 601 en un matériau absorbant pour le rayonnement à détecter, pour former l'absorbeur du microbolomètre du pixel. La couche 601 est par exemple déposée de façon continue sur sensiblement toute la surface du capteur. En particulier, dans l'exemple représenté, la couche 601 est en contact avec la face supérieure de la couche isolante 803, et avec une partie de la face supérieure des piliers de connexion électrique 107a, 107b.

La figure 9B illustre en outre une étape de dépôt, sur et en contact avec la face supérieure de la couche 601, de la couche 801 en un matériau à changement de phase. La couche 801 est par exemple déposée de façon continue sur sensiblement toute la surface du capteur. La couche 801 déposée à l'étape de la figure 9B est par exemple une couche de même nature que la couche 801' déposée à l'étape de la figure 9A. A titre d'exemple, la couche 801 déposée à l'étape de la figure 9B est une couche de dioxyde de vanadium amorphe formée par pulvérisation d'une cible de vanadium à température ambiante dans une atmosphère contenant de l'oxygène. Les couches 801' et 801 ont par exemple sensiblement la même épaisseur. A titre d'exemple, chacune des couches 801' et 801 a une épaisseur comprise entre 10 et 100 nm, par exemple de l'ordre de 50 nm.

La figure 9C illustre une étape de recuit de la structure obtenue à l'issue des étapes de la figure 9B, visant à conférer à la couche 801 les propriétés de conductivité thermique variable recherchées. Lors de cette étape, la couche 801' acquière elle aussi les mêmes propriétés de conductivité thermique variable que la couche 801. A titre d'exemple, dans le cas de couches 801' et 801 en dioxyde de vanadium un recuit à une température de l'ordre de 350 à 400°C peut être mis en oeuvre pour obtenir les propriétés recherchées.

La figure 9D illustre une étape de retrait de la couche 801 sur toute la surface de la future microplanche 103, par exemple par gravure.

La figure 9D illustre en outre une étape ultérieure de gravure d'une tranchée 805 dans la couche 601, visant à séparer l'absorbeur en deux portions disjointes 601-a et 601-b dans la future microplanche bolométrique 103 du pixel. En effet, dans cet exemple, l'absorbeur 601 est en un matériau électriquement conducteur, par exemple du nitrure de titane, et est utilisé non seulement pour sa fonction d'absorbeur, mais aussi pour relier électriquement les extrémités de la thermistance du pixel au circuit 102, par l'intermédiaire des piliers de connexion électrique 107a, 107b. Il convient donc de séparer l'absorbeur en deux portions disjointes, l'une (la portion 601-a) connectée au pilier 107a et à une première extrémité de la thermistance du pixel, et l'autre (la portion 601-b) connectée au pilier 107b et à une deuxième extrémité de la thermistance du pixel. La tranchée 805 s'étend verticalement depuis la face supérieure jusqu'à la face inférieure de la couche 601, et s'interrompt sur la face supérieure de la couche isolante 803. En vue de dessus, la tranchée 805 s'étend par exemple sur toute la largeur de la future microplanche bolométrique 103, dans une partie centrale de la microplanche.

La figure 9D illustre de plus une étape de dépôt, sur la face supérieure de la structure obtenue après la formation de la tranchée 805, d'une deuxième couche électriquement isolante 807, par exemple de même nature que la couche 803, recouvrant la face supérieure de la couche 601, ainsi que les parois latérales et le fond des tranchées 805. La couche 807 est par exemple déposée de façon continue sur sensiblement toute la surface du capteur. Dans chaque pixel, deux ouvertures localisées 809a et 809b sont réalisées dans la couche isolante 807, par exemple par gravure, respectivement en regard de la portion 601-a et en regard de la portion 601-b de l'absorbeur 601, en vue d'une étape ultérieure de reprise de contact électrique sur les portions 601-a et 601-b de l'absorbeur, pour connecter la thermistance du pixel au circuit de lecture 102. Les ouvertures 809a et 809b sont par exemple disposées respectivement au voisinage de deux bords opposés de la microplanche. Dans l'exemple représenté, les ouvertures 809a et 809b s'étendent verticalement sur toute l'épaisseur de la couche isolante 807, et débouchent sur la face supérieure de la couche 601.

La figure 9E illustre une étape de dépôt d'une couche 603 du matériau thermomètre, par exemple du silicium amorphe ou de l'oxyde de vanadium, sur la face supérieure de la structure obtenue à l'issue de l'étape de la figure 9D, pour réaliser la thermistance du pixel. La couche 603 est par exemple déposée de façon continue sur sensiblement toute la surface du capteur, puis gravée pour être conservée seulement sur la microplanche 103 du pixel. La couche 603 est notamment déposée à l'intérieur des ouvertures 809a, 809b de façon que la thermistance 603 soit connectée d'une part (par une première extrémité) au plot 109a du circuit 102 par l'intermédiaire de la portion 601-a de l'absorbeur 601 et du pilier de connexion 107a, et d'autre part (par une deuxième extrémité) au plot 109b du circuit 102 par l'intermédiaire de la portion 601-b de l'absorbeur 601 et du pilier de connexion 107b.

La figure 9E illustre de plus une étape de dépôt d'une troisième couche électriquement isolante 811, par exemple de même nature que les couches 803 et 807, sur la surface supérieure de la structure. La couche 811 est par exemple déposée de façon continue sur sensiblement toute la surface du capteur, et notamment sur et en contact avec la face supérieure et les flancs de la thermistance 603.

La figure 9F illustre une étape ultérieure de retrait des couches isolantes 807 et 811 en dehors de la future microplanche 103 du pixel, et notamment en regard des futurs bras d'isolation thermique 105a, 105b du pixel. A titre d'exemple, les couches 807 et 811 sont retirées partout sauf en regard des microplanches 103 des pixels du capteur.

La figure 9G illustre une étape ultérieure de gravure de l'empilement formé par les couches 801, 601, 803 et 801' de façon à délimiter ou individualiser la microplanche 103 et les bras 105a, 105b du pixel. Lors de cette étape, l'empilement 801-601-803-801' est par exemple retiré partout sauf au niveau des microplanches 103 et des bras 105a, 105b des pixels du capteur.

Le procédé peut ensuite se poursuivre de façon classique, soit directement par le retrait de la couche sacrificielle 301 pour libérer la microplanche 103 et les bras 105a, 105b du pixel, soit, si l'on souhaite former un capot d'encapsulation, par le dépôt d'une deuxième couche sacrificielle puis par la formation du capot d'encapsulation selon des méthodes du type décrit en relation avec les figures 3C à 3F.

Un avantage des capteurs de rayonnement du type décrit en relation avec les figures 8 et 9A à 9G est que chaque pixel du capteur est protégé individuellement contre un éblouissement.

Un autre avantage est que, en l'absence d'éblouissement, le dispositif de protection n'atténue pas le rayonnement à détecter.

Un autre avantage du mode de réalisation des figures 8 et 9A à 9G est que la protection anti-éblouissement obtenue est une protection passive, fonctionnant même en l'absence d'alimentation électrique du capteur.

A titre de variante, la couche 801' du procédé décrit en relation avec les figures 9A à 9G peut être omise, ce qui permet de ne pas ajouter une couche supplémentaire à la microplanche 103 du pixel, et donc de ne pas augmenter la capacité thermique de la microplanche. Un autre avantage est que ceci limite aussi le nombre de couches présentes dans les bras d'isolation thermiques, et donc limite leur conductivité thermique, ce qui permet d'améliorer la sensibilité thermique du pixel.

Divers modes de réalisation avec diverses variantes ont été décrits ci-dessus. On notera que l'homme de l'art pourra combiner divers éléments de ces divers modes de réalisation et variantes sans faire preuve d'activité inventive. En particulier, les protections anti-éblouissement des premier, deuxième et troisième modes de réalisation peuvent être combinées en tout ou partie dans un même pixel d'un capteur de rayonnement. En particulier, on pourra prévoir de combiner la protection active du premier mode de réalisation avec l'une et/ou l'autre des protections passives des deuxième et troisième modes de réalisation, ou combiner les protections passives des deuxième et troisième modes de réalisation sans la protection active du premier mode de réalisation.

## Revendications

1. Capteur de rayonnement comportant une pluralité de pixels (600) formés dans et sur un substrat semiconducteur (101), chaque pixel comportant une microplanche (103) suspendue au-dessus du substrat (101) par des bras d'isolation thermique (105a, 105b), la microplanche (103) comprenant, dans l'ordre à partir de la face supérieure du substrat (101) :
une couche conductrice (601) adaptée à convertir un rayonnement électromagnétique incident en énergie thermique ;
un obturateur optique passif comportant une couche thermochrome (605) revêtant l'une des faces de la couche conductrice (601), la couche thermochrome (605) étant couplée thermiquement à la couche conductrice (601) et présentant un coefficient de réflexion pour le rayonnement à détecter croissant en fonction de sa température ; et
une thermistance (603) revêtant la face de la couche thermochrome (605) opposée à la couche conductrice (601).

2. Capteur selon la revendication 1, dans lequel la distance entre la couche conductrice (601) et la couche thermochrome (605) est inférieure à 20 nm.

3. Capteur selon la revendication 1 ou 2, dans lequel la couche conductrice (601) est en contact avec la couche thermochrome (605).

4. Capteur selon l'une quelconque des revendications 1 à 3, dans lequel l'épaisseur de la couche thermochrome (605) est comprise entre 20 et 60 nm.

5. Capteur selon l'une quelconque des revendications 1 à 4, dans lequel la couche conductrice (601) est séparée en des première (601-a) et deuxième (601-b) portions disjointes par une tranchée d'isolation (705).

6. Capteur selon la revendication 5, dans lequel la surface de la première portion (601-a) est supérieure à la surface de la deuxième portion (601-b).

7. Capteur selon l'une quelconque des revendications 1 à 6, dans lequel la couche thermochrome (605) est en un matériau à changement de phase.

8. Capteur selon la revendication 7, dans lequel la couche thermochrome (605) est en un oxyde métallique présentant une phase isolante transparente pour le rayonnement à détecter et une phase métallique réfléchissante pour le rayonnement à détecter.

9. Capteur selon la revendication 8, dans lequel la couche thermochrome (605) est en un oxyde de vanadium ou un oxyde de titane.

10. Capteur selon la revendication 7, dans lequel la couche thermochrome (605) est en Ag₂S ou en FeS.

11. Capteur selon l'une quelconque des revendications 6 à 10, dans lequel la couche thermochrome (605) présente une température de transition comprise entre 60 et 180°C.

12. Capteur selon l'une quelconque des revendications 1 à 11, dans lequel chaque pixel (600) comprend en outre un circuit (102) de lecture de la valeur de la thermistance (603) du pixel.

13. Capteur selon l'une quelconque des revendications 1 à 12, dans lequel, dans chaque pixel (600), la couche conductrice (601) est en un matériau absorbant pour le rayonnement à détecter.

14. Capteur selon l'une quelconque des revendications 1 à 13, dans lequel, dans chaque pixel (600), la couche conductrice (601) est une couche métallique.

15. Capteur selon l'une quelconque des revendications 1 à 14, dans lequel, dans chaque pixel (600), la couche conductrice (601) est en nitrure de titane.

16. Capteur selon l'une quelconque des revendications 1 à 15, dans lequel, dans chaque pixel (600), les bras d'isolation thermique (105a, 105b) reposent sur des piliers de connexion électrique verticaux (107a, 107b).

17. Capteur selon l'une quelconque des revendications 1 à 16, dans lequel, dans chaque pixel (600), la microplanche (103) et les bras d'isolation thermique (105a, 105b) sont disposés dans une cavité (113) fermée par un capot (111) transparent pour le rayonnement à détecter.

18. Capteur selon la revendication 17, dans lequel, dans chaque pixel (600), le capot transparent (111) ferme hermétiquement la cavité (113), et la cavité (113) est à une pression inférieure à la pression atmosphérique.

## Patentansprüche

1. Strahlungssensor, mit einer Vielzahl von Pixeln (600), die in und auf einem Halbleitersubstrat (101) ausgebildet sind, wobei jedes Pixel ein Mikroelement (103) aufweist, das durch thermisch isolierende Arme (105a, 105b) über dem Substrat (101) aufgehängt ist, wobei das Mikroelement (103) in der Reihenfolge, beginnend von der Oberseite des Substrats (101), Folgendes aufweist:
eine leitende Schicht (601), die geeignet ist, einfallende elektromagnetische Strahlung in thermische Energie umzuwandeln;
eine passive optische Blende mit einer wärmeempfindlichen Schicht (605), die eine der Seiten der leitenden Schicht (601) abdeckt, wobei die wärmeempfindliche Schicht (605) thermisch mit der leitenden Schicht (601) gekoppelt ist und einen Reflexionskoeffizienten für die zu erfassende Strahlung aufweist, der in Abhängigkeit ihrer Temperatur zunimmt; und
einen Thermistor (603), der die der leitenden Schicht (601) entgegengesetzten Seite der wärmeempfindlichen Schicht (605) abdeckt.

2. Sensor nach Anspruch 1, wobei der Abstand zwischen der leitenden Schicht (601) und der wärmeempfindlichen Schicht (605) kleiner als 20 nm ist.

3. Sensor nach Anspruch 1 oder 2, wobei die leitende Schicht (601) in Kontakt mit der wärmeempfindlichen Schicht (605) steht.

4. Sensor nach einem der Ansprüche 1 bis 3, wobei die Dicke der wärmeempfindlichen Schicht (605) zwischen 20 und 60 nm liegt.

5. Sensor nach einem der Ansprüche 1 bis 4, wobei die leitende Schicht (601) durch einen Isolationsgraben (705) in erste (601-a) und zweite (601-b) getrennte Abschnitte getrennt ist.

6. Sensor nach Anspruch 5, wobei der Oberflächenbereich des ersten Abschnitts (601-a) größer ist als der Oberflächenbereich des zweiten Abschnitts (601-b).

7. Sensor nach einem der Ansprüche 1 bis 6, wobei die wärmeempfindliche Schicht (605) aus einem Phasenwechselmaterial hergestellt ist.

8. Sensor nach Anspruch 7, wobei die wärmeempfindliche Schicht (605) aus einem Metalloxid mit einer isolierenden Phase, die für die zu detektierende Strahlung transparent ist, und einer Metallphase, die für die zu detektierende Strahlung reflektierend ist, hergestellt ist.

9. Sensor nach Anspruch 8, wobei die wärmeempfindliche Schicht (605) aus einem Vanadiumoxid oder einem Titanoxid hergestellt ist.

10. Sensor nach Anspruch 7, wobei die wärmeempfindliche Schicht (605) aus Ag₂S oder aus FeS hergestellt ist.

11. Sensor nach einem der Ansprüche 6 bis 10, wobei die wärmeempfindliche Schicht (605) eine Übergangstemperatur zwischen 60 und 180°C aufweist.

12. Sensor nach einem der Ansprüche 1 bis 11, wobei jedes Pixel (600) ferner eine Leseschaltung (102) zum Lesen des Wertes des Thermistors (603) des Pixels aufweist.

13. Sensor nach einem der Ansprüche 1 bis 12, wobei in jedem Pixel (600) die leitende Schicht (601) aus einem Material besteht, das für die zu erfassende Strahlung absorbierend ist.

14. Sensor nach einem der Ansprüche 1 bis 13, wobei in jedem Pixel (600) die leitende Schicht (601) eine Metallschicht ist.

15. Sensor nach einem der Ansprüche 1 bis 14, wobei in jedem Pixel (600) die leitende Schicht (601) aus Titannitrid hergestellt ist.

16. Sensor nach einem der Ansprüche 1 bis 15, wobei in jedem Pixel (600) die thermisch isolierenden Arme (105a, 105b) auf vertikalen elektrischen Anschlusspfosten (107a, 107b) liegen.

17. Sensor nach einem der Ansprüche 1 bis 16, wobei in jedem Pixel (600) das Mikroelement (103) und die thermisch isolierenden Arme (105a, 105b) in einem Hohlraum (113) angeordnet sind, der durch eine für die zu erfassende Strahlung transparente Deckschicht (111) verschlossen ist.

18. Sensor nach Anspruch 17, wobei in jedem Pixel (600) die transparente Deckschicht (111) den Hohlraum (113) hermetisch verschließt und sich der Hohlraum (113) auf einem Druck befindet, der niedriger ist als der Atmosphärendruck.

## Claims

1. A radiation sensor comprising a plurality of pixels (600) formed in and on a semiconductor substrate (101), each pixel comprising a microboard (103) suspended above the substrate (101) by thermal insulation arms (105a, 105b), the microboard (103) comprising, in order starting from the upper face of the substrate (101) :
a conducting layer (601) adapted to convert incident electromagnetic radiation into thermal energy;
a passive optical shutter comprising a heat-sensitive layer (605) covering one of the faces of the conducting layer (601), the heat-sensitive layer (605) being thermally coupled to the conducting layer (601) and having a reflection coefficient for the radiation to be detected that increases as a function of its temperature; and
a thermistor (603) covering the face of the heat-sensitive layer (605) opposite the conducting layer (601).

2. The sensor according to claim 1, wherein the distance between the conducting layer (601) and the heat-sensitive layer (605) is less than 20 nm.

3. The sensor according to claim 1 or 2, wherein the conducting layer (601) is in contact with the heat-sensitive layer (605) .

4. The sensor according to any of claims 1 to 3, wherein the thickness of the heat-sensitive layer (605) is comprised between 20 and 60 nm.

5. The sensor according to any of claims 1 to 4, wherein the conducting layer (601) is separated into first (601-a) and second (601-b) disjunct portions by an isolation trench (705).

6. The sensor according to claim 5, wherein the surface area of the first portion (601-a) is greater than the surface area of the second portion (601-b).

7. The sensor according to any of claims 1 to 6, wherein the heat-sensitive layer (605) is made of a phase-change material.

8. The sensor according to claim 7, wherein the heat-sensitive layer (605) is made of a metal oxide having an insulating phase that is transparent for the radiation to be detected and a metal phase that is reflective for the radiation to be detected.

9. The sensor according to claim 8, wherein the heat-sensitive layer (605) is made of a vanadium oxide or a titanium oxide.

10. The sensor according to claim 7, wherein the heat-sensitive layer (605) is made of Ag₂S or of FeS.

11. The sensor according to any of claims 6 to 10, wherein the heat-sensitive layer (605) has a transition temperature comprised between 60 and 180°C.

12. The sensor according to any of claims 1 to 11, wherein each pixel (600) further comprises a read circuit (102) for reading the value of the thermistor (603) of the pixel.

13. The sensor according to any of claims 1 to 12, wherein, in each pixel (600), the conducting layer (601) is made of a material that is absorbent for the radiation to be detected.

14. The sensor according to any of claims 1 to 13, wherein, in each pixel (600), the conducting layer (601) is a metal layer.

15. The sensor according to any of claims 1 to 14, wherein, in each pixel (600), the conducting layer (601) is made of titanium nitride.

16. The sensor according to any of claims 1 to 15, wherein, in each pixel (600), the thermal insulation arms (105a, 105b) lie on vertical electrical connection posts (107a, 107b).

17. The sensor according to any of claims 1 to 16, wherein, in each pixel (600), the microboard (103) and the thermal insulation arms (105a, 105b) are disposed in a cavity (113) closed by a cap (111) that is transparent for the radiation to be detected.

18. The sensor according to claim 17, wherein, in each pixel (600), the transparent cap (111) hermetically closes the cavity (113), and the cavity (113) is at a pressure that is lower than the atmospheric pressure.
